# EUROPÄISCHE PATENTSCHRIFT

(11) **EP 3 729 486 B1**
(45) Veröffentlichungstag und Bekanntmachung des Hinweises auf die Patenterteilung: **30.08.2023**
(21) Anmeldenummer: 18829350.0
(22) Anmeldetag: 19.12.2018
(51) Int. Cl.: H01J 37/32, H05H 1/28

(54) **SYSTEM ZUR ELEKTRISCH ENTKOPPELTEN, HOMOGENEN TEMPERIERUNG EINER ELEKTRODE MITTELS WÄRMELEITROHREN SOWIE BEARBEITUNGSANLAGE MIT EINEM SOLCHEN SYSTEM**
SYSTEM FOR ELECTRICALLY DECOUPLED, HOMOGENEOUS TEMPERATURE CONTROL OF AN ELECTRODE BY MEANS OF HEAT CONDUCTION TUBES, AND PROCESSING FACILITY COMPRISING SUCH A SYSTEM
SYSTÈME DE CONTRÔLE THERMIQUE HOMOGÈNE ÉLECTRIQUEMENT DÉCOUPLÉ D'UNE ÉLECTRODE AU MOYEN DE TUBES THERMOCONDUCTEURS ET INSTALLATION DE TRAITEMENT COMPRENANT LEDIT SYSTÈME

(30) Priorität: 21.12.2017 DE 102017223592
(43) Veröffentlichungstag der Anmeldung: 28.10.2020
(73) Patentinhaber: Meyer Burger (Germany) GmbH, 09337 Hohenstein-Ernstthal (DE)
(72) Erfinder: BÖHM, Christian, 09337 Hohenstein-Ernstthal (DE); RASCHKE, Sebastian, 09380 Thalheim (DE)
(74) Vertreter: Kailuweit & Uhlemann Patentanwälte Partnerschaft mbB
(86) Internationale Anmeldenummer: PCT/EP2018/085820
(87) Internationale Veröffentlichungsnummer: WO 2019/121899

(56) Entgegenhaltungen:
- DE-A1-102015 113 962
- DE-U1-202010 004 109
- DE-U1-202010 004 109
- US-A- 6 027 701

## Beschreibung

Die Erfindung betrifft ein System zur Temperierung einer oder mehrerer Elektroden. Dabei wird die Temperierung der Elektrode(n) über Wärmeleitrohre realisiert, wodurch eine homogene Temperierung und eine elektrische Entkopplung der Elektrode(n) von einer Temperiervorrichtung ermöglicht wird. Darüber hinaus betrifft die Erfindung eine Bearbeitungsanlage mit einem solchen System.

In zahlreichen Verfahren der Halbleitertechnik, wie bspw. der Solarzellenherstellung, und der Oberflächentechnik, wie bspw. der Beschichtung von optischen Gläsern, werden Behandlungsprozesse eingesetzt, bei denen Energie über eine Elektrode eingebracht wird. Insbesondere Plasmaprozesse zum Aufbringen, Entfernen oder Modifizieren von Schichten sind dafür Beispiele. Die genutzten Elektroden können dabei auch als Substrathalter oder Gaszuführung dienen. Oftmals soll eine genutzte Elektrode auf einer bestimmten Temperatur gehalten werden, bspw. um ein oder mehrere Substrate auf eine, für den vorgesehenen Prozess geeignete Temperatur zu bringen oder dort zu halten oder um ein zu starkes Aufheizen der Elektrode zu verhindern.

Um eine homogene Temperierung einer solchen Elektrode zu erreichen, werden gewöhnlich Fluid-Systeme oder resistive Heizer als Temperiervorrichtung genutzt. Bei einem Fluid-System wird die Elektrode durch ein Fluid, bspw. Öl, Wasser oder Gas, durchströmt, wobei das Fluid von außen zugeführt und wieder nach außen abgeführt wird. Resistive Heizer sind entweder als flächige Elemente oder als gerade oder gewundene Heizdrähte auf oder in der Elektrode angeordnet, wobei dem Heizer von außen elektrische Energie unabhängig von der Elektrodenleistung zugeführt wird. In beiden Fällen wird jedoch ein Teil der Elektrodenleistung durch die Temperiervorrichtung nach außen abgeführt, wodurch die für den eigentlichen Bearbeitungsprozess zur Verfügung stehende Leistung reduziert und gegebenenfalls auch Komponenten der Temperiervorrichtung selbst beeinträchtigt werden. Daher werden oftmals aufwendige Isolationen oder Filterschaltungen notwendig, um die Temperiervorrichtung elektrisch von der Elektrode zu entkoppeln. Dies ist insbesondere für Hochfrequenzelektroden, d.h. bei Elektrodenleistungen mit einer Frequenz im Bereich von 10 kHz bis 100 MHz, bedeutsam.

Des Weiteren weist ein Fluid-System, insbesondere wenn Öl als Fluid genutzt wird, noch weitere Nachteile auf. So ist die mit Hilfe einer Ölheizung erreichbare Temperatur der Elektrode bzw. eines Substrathalters begrenzt, bspw. auf ca. 350°C. Darüber hinaus tritt auf Grund der Wärmeabgabe durch das Fluid während der Strömung durch die Elektrode oder den Substrathalter ein Temperaturunterschied von mehreren Kelvin zwischen dem Ort des Fluideintritts und dem Ort des Fluidaustritts in die bzw. aus der Elektrode auf, wodurch die Elektrode nicht homogen temperiert werden kann. Nicht zuletzt besteht bei Fluid-Systemen, insbesondere bei Öl-basierten Temperiervorrichtungen, die Gefahr eines Lecks innerhalb der Prozessanlage, was mit einem großen Aufwand zur Reinigung der Anlage verbunden ist.

Nachteilig an resistiven Heizern ist, dass diese nur ein Heizen der Elektrode bzw. des Substrathalters erlauben, jedoch keine aktive Kühlung.

Prinzipiell bekannt ist auch der Einsatz von Wärmeleitrohren, auch Heatpipes genannt, insbesondere zur Kühlung von Elementen in Beschichtungsanlagen. So beschreibt bspw. die WO 95/16804 A1 die Kühlung einer Gasverteilplatte mittels eines Wärmeleitrohres, welches senkrecht zur Ausströmoberfläche der Gasverteilplatte verläuft und an einem Ende von einem Kühlmantel, durch den eine Kühlflüssigkeit strömt und die dabei in direktem Kontakt zur Oberfläche des Wärmeleitrohres steht, umgeben ist. Auch in der EP 2 481 831 A1 ist der Einsatz von Wärmeleitrohren zum Abführen von Wärme aus einer Hochfrequenzelektrode erwähnt, während das Aufheizen der Elektrode über einen Heizkatalysator, einen resistiven Heizer oder ein Heizfluid erfolgt. In der US 6 027 701 A wird ein herkömmliches Kühlsystem für Elektroden ohne Wärmeleitrohre offenbart. In der DE 20 2010 004109 U1 wird eine Brückenverbindung für Wärmeleitrohre offenbart.

Es ist Aufgabe der Erfindung, ein verbessertes System zur Temperierung einer Elektrode, insbesondere einer Hochfrequenzelektrode, und eine Behandlungsanlage mit einem solchen System zur Verfügung zu stellen, wobei eine gute elektrische Entkopplung zwischen einer Temperiervorrichtung und der Elektrode gewährleistet ist und andere Nachteile bisheriger Temperiersysteme vermieden oder reduziert werden.

Die Aufgabe wird gelöst durch ein System sowie eine Behandlungsanlage gemäß der unabhängigen Ansprüche. Bevorzugte Ausführungsformen finden sich in den Unteransprüchen.

Das erfindungsgemäße System zur Temperierung einer Elektrode weist mindestens ein Wärmeleitrohr, ein Koppelelement und eine Temperiervorrichtung auf. Das Wärmeleitrohr ist geeignet, zumindest teilweise und mit mindestens einem ersten Ende in der Elektrode angeordnet zu werden, während das Koppelelement geeignet ist, ein zweites Ende des Wärmeleitrohrs aufzuheizen oder zu kühlen. Die Temperiervorrichtung wiederum ist geeignet, das Koppelelement aufzuheizen oder zu kühlen und dient damit als Wärmequelle oder Wärmesenke bezüglich der Elektrode. Dabei sind die Elektrode und die Temperiervorrichtung galvanisch voneinander getrennt, so dass die Temperiervorrichtung von der Elektrode elektrisch entkoppelt ist. Die Elektrode an sich ist nicht notwendigerweise Bestandteil des erfindungsgemäßen Systems zur Temperierung der Elektrode, jedoch sind die Elektrode und das System zur Temperierung der Elektrode aufeinander abgestimmt und geeignet, miteinander gekoppelt zu werden. Dazu ist die Elektrode mindestens geeignet, mindestens das erste Ende des Wärmeleitrohres in ihrem Inneren aufzunehmen.

Wärmeleitrohre, auch Heatpipes genannt, sind Rohre aus einem Hüllmaterial, die mit einer speziellen Innenstruktur, bspw. Kapillaren oder einem eingelegten Drahtgeflecht, versehen sind. Im abgeschlossenen Volumen eines Wärmeleitrohres befindet sich ein Arbeitsmedium, welches das Volumen teils in flüssigem, teils in dampfförmigen Zustand ausfüllt. Dabei wird Wärme vom Ort eines Wärmeeintrags, an dem das Arbeitsmedium verdampft, zum Ort einer Wärmeabgabe, an dem das Arbeitsmedium wieder kondensiert, übertragen. Aufgrund der hohen Wärmestromdichte lassen sich somit große Wärmeströme, bspw. 50 W bei relativ kleinen Wärmeeintragsflächen, bspw. 5 cm², über relativ große Strecken, bspw. 40 cm, in sehr kurzer Zeit, bspw. innerhalb weniger Sekunden, mit einem sehr kleinen Temperaturgefälle über die gesamte Länge des Wärmeleitrohres von ca. 0,5 K transportieren. Dem Fachmann sind verschiedenste Ausführungsformen von Wärmeleitrohren bekannt. Das Hüllmaterial kann bspw. ein Metall, wie Aluminium, Kupfer, vernickeltes Kupfer, Edelstahl oder Legierungen aus verschiedenen Metallen, aber auch Glas oder Keramik oder ein Verbundwerkstoff sein. Das Rohr kann dabei einen kreisrunden, ovalen, vier- oder n-eckigen oder anderen beliebigen Querschnitt aufweisen, wobei der Querschnitt auch sehr flach (nahezu bandförmig oder flächig) gestaltet sein kann. Als Arbeitsmedien können je nach gewünschtem Temperaturbereich bspw. Wasser, Natrium, Lithium oder Quecksilber zum Einsatz kommen. Die Anzahl und Form der Wärmeleitrohre sowie die Anordnung der Wärmeleitrohre bei Verwendung mehrerer Wärmeleitrohre kann entsprechend der zu übertragenden Wärmemenge und der Geometrie der Elektrode ausgewählt werden. Dabei kann ein Wärmeleitrohr als gerader Stab oder in gebogener Form ausgeführt sein, wobei auch mehrere Biegungen, z.B. in Mäanderform, oder dreidimensionale Biegungen möglich sind.

Die Wärmekopplung des Wärmeleitrohrs an die Elektrode erfolgt über Wärmeleitung, wobei das Wärmeleitrohr in die Elektrode gesteckt, geklemmt, geschraubt, geklebt oder eingelötet sein kann.

Der Fachmann wählt die Materialien und die Geometrie des mindestens einen Wärmeleitrohrs, seine Anordnung und die Art der Befestigung innerhalb der Elektrode entsprechend der vorliegenden Randbedingungen, z.B. Prozessgase, zu erreichende Elektrodentemperatur, Material der Elektrode, Übertragung einer Elektrodenspannung etc., mit Hilfe seiner Kenntnisse aus. So können bspw. metallische Wärmeleitrohre zur Zuführung einer Elektrodenspannung von einer Spannungsversorgung an die Elektrode genutzt werden.

Die Elektrode kann aus verschiedenen Materialien oder aus Schichtaufbauten aus verschiedenen Materialien bestehen, wobei jedoch zumindest ein Bestandteil der Elektrode elektrisch leitfähig ist, um eine gewünschte Verteilung des elektrischen Potentials über die Elektrode zu erreichen. Typische Elektrodenmaterialien sind Aluminium, Graphit, Edelstahl oder Verbundmaterialien. Oftmals ist die Elektrode ein flacher Körper, der zwei sich gegenüberliegende Oberflächen mit - bezogen auf den Abstand dieser Oberflächen - großen lateralen Abmessungen aufweist. Mindestens eine dieser Oberflächen dient der Erzeugung eines elektrischen Feldes und/oder der Halterung eines oder mehrerer Substrate und wird im Folgenden als Nutzfläche bezeichnet. Damit soll auch ein Substrathalter, der nicht mit einer elektrischen Spannung beaufschlagt wird und der entweder geerdet ist oder floatet, im Sinne dieser Anmeldung als Elektrode verstanden werden. Jedoch kann die Elektrode bspw. auch ein Gasverteiler sein oder einen solchen enthalten. Die elektrische Beschaltung der Elektrode kann mit Gleichspannung oder Wechselspannungen von niederen bis hohen Frequenzen erfolgen, wobei das erfindungsgemäße System besonders zur Temperierung einer Elektrode, welche mit einer hochfrequenten Spannung, bspw. mit einer Frequenz von 13,56 MHz oder 40 MHz, beaufschlagt wird, geeignet ist. Die Elektrode kann aus einem Stück oder aus mehreren Teilen, bspw. aus Halbschalen, bestehen, wobei die einzelnen Teile durch Nieten, Schweißen, Löten, Kleben, Schrauben, Klemmen oder andere Fügetechniken miteinander verbunden sind. In der Elektrode sind vorzugsweise Aussparungen zur Aufnahme des mindestens einen Wärmeleitrohres ausgebildet, in die das oder die Wärmeleitrohre eingesteckt, eingeschraubt oder eingelegt werden können. Das oder die Wärmeleitrohre erstrecken sich zumindest teilweise mit ihrer Längsausdehnung (zwischen dem ersten und dem zweiten Ende des Wärmeleitrohrs) parallel zu der Nutzfläche der Elektrode.

Das Koppelelement, welches mit Hilfe der Temperiervorrichtung aufgeheizt oder gekühlt wird, dient der Übertragung einer Wärmemenge an das oder von dem mindestens einen Wärmeleitrohr.

In einer ersten Ausführungsform ist das Koppelelement mindestens ein Teil einer Außenfläche der Elektrode, wobei das zweite Ende des Wärmeleitrohrs an diesen Teil der Außenfläche angrenzt. Das Koppelelement besteht dabei nur aus einer Wärmeübertragungsfläche, die dem Teil der Außenfläche der Elektrode entspricht, wobei die Wärmeübertragungsfläche gegenüber anderen Bereichen der Elektrode einen erhöhten thermischen Absorptionsgrad aufweist. Dazu kann dieser Teil der Außenfläche der Elektrode bspw. mit Ruß, Graphit oder Lack geschwärzt, dessen Oberfläche aufgeraut oder mit einer anderen hochabsorbierenden, dünnen (Dicke kleiner oder gleich 50 µm) Beschichtung versehen werden. Bspw. kann eine Aluminium-Elektrode an der Außenfläche eloxiert werden. Vorzugsweise ist die Außenfläche, die das Koppelelement aufweist, keine Nutzfläche der Elektrode. Weiterhin vorzugsweise bildet die gesamte Fläche der Außenfläche das Koppelelement. Die erste Ausführungsform ist besonders für die Verwendung eines Infrarot-Strahlers als Temperiervorrichtung geeignet, wobei das Koppelelement einen thermischen Absorptionsgrad (Emissivität) im Spektralbereich des Infrarot-Strahlers von größer oder gleich 0,5, vorzugsweise im Bereich von 0,7 bis 0,9 hat, während die übrigen Bereiche der Elektrode je nach Beschichtungsgrad eine Emissivität von ca. 0,2 hat. Die Fläche des Koppelelements ist vorzugsweise wesentlich kleiner als die Nutzfläche der Elektrode und beträgt bspw. weniger als 15% der Nutzfläche und bspw. weniger als 10 % der gesamten Elektrodenoberfläche (Ober- und Unterseite sowie Außenseiten der Elektrode). Die Wärmekopplung des Wärmeleitrohrs an das Koppelelement erfolgt über Wärmeleitung. Das oder die Wärmeleitrohre erstrecken sich von dem Koppelelement über die Nutzfläche der Elektrode innerhalb der Elektrode hinweg, so dass die Wärme gleichmäßig über die Nutzfläche der Elektrode verteilt und die Nutzfläche homogen temperiert wird, bspw. mit einem Temperaturunterschied von 0,5 K über die gesamte Ausdehnung der Nutzfläche.

In einer zweiten Ausführungsform des erfindungsgemäßen Systems ist das Koppelelement ein von der Elektrode getrennter Körper aus einem Material mit einer hohen Wärmeleitfähigkeit, wobei das Koppelelement geeignet ist, in einem Bereich der Außenfläche der Elektrode angeordnet zu werden, der an einen Volumenbereich der Elektrode angrenzt, in dem mindestens das zweite Ende des Wärmeleitrohrs anordenbar ist. Das heißt, das Wärmeleitrohr wird bei Nutzung des erfindungsgemäßen Systems vollständig innerhalb der Elektrode angeordnet, während das Koppelelement an eine Außenfläche der Elektrode in dem Bereich, in dem das zweite Ende des Wärmeleitrohrs liegt, angrenzt und physisch, bspw. über Klemmen oder Schrauben, so mit der Elektrode verbunden ist, dass eine gute Wärmeleitung zwischen dem Koppelelement und der Elektrode vorliegt. Das Koppelelement überträgt damit mittels Wärmeleitung durch das zwischen ihm und dem zweiten Ende des Wärmeleitrohrs befindliche Elektrodenmaterial Wärme an das Wärmeleitrohr oder führt Wärme von diesem ab. Das Koppelelement kann aus demselben Material wie die Elektrode oder aus einem anderen Material bestehen und weist im Bereich der gewünschten Elektrodentemperatur eine Wärmeleitfähigkeit von größer oder gleich 20 W/(m•K), vorzugsweise größer oder gleich 150 W/(m•K) auf, die vorzugsweise größer oder gleich der Wärmeleitfähigkeit des Materials der Elektrode ist. Gegebenenfalls sind bei der Materialauswahl des Koppelelements auch die Verträglichkeit gegenüber Prozessumgebungen, die bei der Nutzung der Elektrode für einen Behandlungsprozess vorliegen, zu beachten. Die Kontaktfläche des Koppelelements zur Elektrode, die eine Wärmeeintragsfläche in die Elektrode ist, ist vorzugsweise wesentlich kleiner als die Nutzfläche der Elektrode und beträgt bspw. weniger als 15 % der Nutzfläche und bspw. weniger als 10 % der gesamten Elektrodenoberfläche (Ober- und Unterseite sowie Außenseiten der Elektrode).

In einer dritten Ausführungsform des erfindungsgemäßen Systems ist das Koppelelement ein von der Elektrode getrennter Körper aus einem Material mit einer hohen Wärmeleitfähigkeit, in dem mindestens das zweite Ende des Wärmeleitrohrs angeordnet ist. Das Koppelelement ist dabei vorzugsweise physisch nicht direkt mit der Elektrode verbunden, kann aber an diese angrenzen. Dies ist vorteilhaft, wenn die Materialien des Koppelelements und der Elektrode einen unterschiedlichen Wärmeausdehnungskoeffizienten aufweisen. Ist dieser für das Koppelelement und die Elektrode gleich oder nahezu gleich, so kann das Koppelelement auch physisch, bspw. über Schrauben oder Klemmen, mit der Elektrode verbunden sein. Das Koppelelement kann aus demselben Material wie die Elektrode oder aus einem anderen Material bestehen und weist im Bereich der gewünschten Elektrodentemperatur eine Wärmeleitfähigkeit von größer oder gleich 20 W/(m•K), vorzugsweise größer oder gleich 150 W/(m•K) auf, die vorzugsweise größer oder gleich der Wärmeleitfähigkeit des Materials der Elektrode ist. Gegebenenfalls sind bei der Materialauswahl des Koppelelements auch die Verträglichkeit gegenüber Prozessumgebungen, die bei der Nutzung der Elektrode für einen Behandlungsprozess vorliegen, zu beachten.

Die Wärmekopplung des Wärmeleitrohrs an das Koppelelement erfolgt in der dritten Ausführungsform über Wärmeleitung, wobei das Wärmeleitrohr in das Koppelelement gesteckt, geklemmt, geschraubt, geklebt oder eingelötet sein kann. Das Koppelelement kann - ähnlich wie die Elektrode - aus einem Stück oder aus mehreren Teilen, bspw. aus Halbschalen, bestehen, wobei die einzelnen Teile durch Nieten, Schweißen, Löten, Kleben, Schrauben, Klemmen oder andere Fügetechniken miteinander verbunden sind. Im Koppelelement sind vorzugsweise Aussparungen zur Aufnahme des mindestens einen Wärmeleitrohres ausgebildet, in die das oder die Wärmeleitrohre eingesteckt, eingeschraubt oder eingelegt werden können.

In einer spezifischen Ausgestaltung der zweiten oder dritten Ausführungsform besteht das Koppelelement aus einem elektrisch leitenden Material, wie bspw. Aluminium, Kupfer, Kupfer vernickelt oder Graphit. Wenn in dieser Ausführungsform das Koppelelement an die Elektrode angrenzt oder das Wärmeleitrohr ein elektrisch leitfähiges Hüllmaterial aufweist, liegt das Koppelelement auf demselben elektrischen Potential wie die Elektrode. Darüber hinaus kann die Elektrode dann auch über das Koppelelement und/oder das Wärmeleitrohr mit einer Elektrodenspannung beaufschlagt werden.

In einer anderen spezifischen Ausgestaltung der zweiten oder dritten Ausführungsform besteht das Koppelelement aus einem elektrisch isolierenden Material, wie bspw. einer Oxidkeramik, z.B. Al₂O₃, oder einer Nichtoxidkeramik, z.B. Aluminiumnitrid.

Vorzugsweise weist das Koppelelement der zweiten oder dritten Ausführungsform des erfindungsgemäßen Systems eine Wärmeübertragungsfläche auf, die eine Außenfläche des Koppelelements ist und über die das Koppelelement mit der Temperiervorrichtung interagiert. Unter "Außenfläche des Koppelelements" wird auch die Oberfläche einer in das Koppelelement eingebrachten Bohrung verstanden, wobei die Temperiervorrichtung zumindest teilweise innerhalb der Bohrung angeordnet ist. Die Wärmeübertragungsfläche weist einen gegenüber anderen Bereichen des Koppelelements erhöhten thermischen Absorptionsgrad oder eine erhöhte Wärmeleitfähigkeit auf. Dazu kann die Wärmeübertragungsfläche geschwärzt, aufgeraut oder mit einer hochabsorbierenden dünnen Beschichtung versehen werden, wie dies bereits bezüglich des Koppelelements der ersten Ausführungsform beschrieben ist. Vorzugsweise ist der thermische Absorptionsgrad im Wellenlängenbereich der Temperiervorrichtung größer oder gleich 0,5, vorzugsweise im Bereich von 0,7 bis 0,9. Wird Wärme zwischen der Temperiervorrichtung und dem Koppelelement mittels Wärmeleitung übertragen, so kann die Wärmeübertragungsfläche auch mit einer Beschichtung, die eine besonders hohe Wärmeleitfähigkeit aufweist, versehen sein, z.B. mit einer Schicht aus Graphen, Kupfer, Silber oder Gold. Die Wärmeübertragungsfläche weist vorzugsweise eine Wärmeleitfähigkeit von größer oder gleich 150 W/(m•K) auf. Um eine besonders gute Wärmeankopplung an die Temperiervorrichtung zu erreichen, ist die Wärmeübertragungsfläche vorzugsweise eine vergrößerte Fläche. Das heißt, dass die Wärmeübertragungsfläche bspw. eine größere Höhe oder Breite als die ihr gegenüberliegende Außenfläche des Koppelelements aufweist. Jedoch ist die Wärmeübertragungsfläche des Koppelelements vorzugsweise wesentlich kleiner als die Nutzfläche der Elektrode und beträgt bspw. weniger als 15 % der Nutzfläche und bspw. weniger als 10 % der gesamten Elektrodenoberfläche (Ober- und Unterseite sowie Außenseiten der Elektrode).

Die Temperiervorrichtung ist vorzugsweise ein Infrarot-Strahler, der Wärme über Wärmestrahlung an das Koppelelement überträgt, oder ein Induktor, der mit Hilfe eines magnetischen Wechselfeldes im Material des Koppelelements Wirbelströme induziert. In beiden Fällen kann die Temperiervorrichtung von dem Koppelelement beabstandet angeordnet werden, so dass auch bei einem elektrisch leitfähigen Koppelelement bzw. bei einem elektrisch leitfähigen Koppelelement und einem elektrisch leitfähigen Wärmeleitrohr keine direkte oder galvanische elektrische Kopplung zwischen der Temperiervorrichtung und der Elektrode vorliegt. Für den Fall der Nutzung eines Infrarot-Strahlers als Temperiervorrichtung kann auch ein für die InfrarotStrahlen durchlässiges, jedoch elektrisch isolierendes Material, wie bspw. Quarzglas, zwischen dem Infrarot-Strahler und dem Koppelelement angeordnet sein und die elektrische Entkopplung der Temperiervorrichtung und der Elektrode gewährleisten.

Um eine Kühlung des Koppelelements mittels Wärmestrahlung zu erreichen, kann die Temperiervorrichtung auch ein stark gekühlter Kühlkörper sein. So könnte bspw. eine Graphitfläche gegenüber der Wärmeübertragungsfläche des Koppelelements angeordnet und gekühlt werden und damit als Strahlungssenke für das Koppelelement dienen.

In anderen bevorzugten Ausführungsformen ist die Temperiervorrichtung ein resistiver Heizer oder eine fluidbasierte Vorrichtung, welche über Wärmeleitung Wärme an das Koppelelement überträgt oder - bei einer fluidbasierten Vorrichtung - von diesem abführt. Besteht das Koppelelement oder - bei einem von der Elektrode beabstandeten Koppelelement - mindestens das Wärmeleitrohr aus einem elektrisch isolierenden Material, so kann die Temperiervorrichtung direkt an das Koppelelement angrenzen. Bestehen das Koppelelement und das Wärmeleitrohr aus einem elektrisch leitfähigen Material, so ist zwischen der Temperiervorrichtung und der Wärmeübertragungsfläche des Koppelelements noch ein elektrischer Isolator angeordnet. Mit dieser Ausgestaltung sind zwar die Temperiervorrichtung und die Elektrode nicht vollständig elektrisch voneinander entkoppelt, aber die elektrischen Verluste sind verringert und gut berechenbar und können damit bei der Spannungsversorgung der Elektrode einfach berücksichtigt werden.

In einer weiteren Ausführungsform enthält das System weiterhin eine Temperaturmesseinheit und eine Steuereinheit, wobei die Temperaturmesseinheit geeignet ist, einen mit der Temperatur des Koppelelements verknüpften Parameter zu ermitteln, und die Steuereinheit geeignet ist, die Temperiervorrichtung zu steuern. Die Temperaturmesseinheit kann dabei ein Thermoelement enthalten, welches direkt am Koppelelement angeordnet ist. Bei einem Koppelelement aus einem elektrisch leitenden Material ist das Thermoelement vorzugsweise elektrisch vom Koppelelement entkoppelt. In anderen Varianten kann die Temperaturmesseinheit ein Pyrometer oder faseroptische Sensoren enthalten. Die Steuereinheit steuert die Temperiervorrichtung entsprechend der mit Hilfe der Temperaturmesseinheit ermittelten tatsächlichen Temperatur des Koppelelements und einer vorgegebenen Solltemperatur des Koppelelements.

Die erfindungsgemäße Behandlungsanlage weist eine Behandlungskammer und mindestens eine Elektrode innerhalb der Behandlungskammer sowie mindestens ein erfindungsgemäßes System zur Temperierung einer Elektrode auf. Enthält die Behandlungskammer mehr als eine Elektrode, so ist vorzugsweise jeder Elektrode jeweils ein individuelles System zur Temperierung der Elektrode zugeordnet. Das heißt, dass das mindestens eine Wärmeleitrohr und die Koppeleinheit eines jeden Systems zur Temperierung einer Elektrode genau einer Elektrode zugeordnet sind, wobei jedoch eine Temperiervorrichtung auch zur gleichzeitigen Temperierung mehrerer Elektroden bzw. Koppelelemente genutzt werden kann. Alternativ ist es auch möglich, dass Wärmeleitrohre, die jeweils mit einer, aber jeweils einer verschiedenen der Elektroden verbunden sind, mit nur einem Koppelelement verbunden sind und somit ein Koppelelement mehreren Elektroden zugeordnet ist. Vorzugsweise ist die Behandlungsanlage geeignet, innerhalb der Behandlungskammer ein Vakuum zu erzeugen, und weist entsprechende Vorrichtungen und Eigenschaften dafür auf.

Vorzugsweise ist die Temperiervorrichtung mindestens eines ersten Systems zur Temperierung einer Elektrode außerhalb der Behandlungskammer angeordnet. Alternativ kann die Temperiervorrichtung jedoch auch innerhalb der Behandlungskammer angeordnet sein. So kann beispielsweise ein Infrarot-Strahler, der innerhalb eines Hüllrohres, bspw. aus Quarzglas, angeordnet ist, innerhalb der Behandlungskammer angeordnet sein. Diese Variante hat den Vorteil, dass das Hüllrohr gegenüber einer Atmosphäre innerhalb der Behandlungskammer, z.B. Vakuum, abgedichtet ist und somit im Inneren des Hüllrohrs eine definierte Gaszusammensetzung bei Atmosphärendruck herrscht. Dadurch gibt es keine Einschränkungen bei der Betriebsspannung des Infrarot-Strahlers.

In einer bevorzugten Ausführungsform ist die Temperiervorrichtung eines ersten Systems zur Temperierung einer Elektrode außerhalb der Behandlungskammer und das Koppelelement des ersten Systems vollständig innerhalb der Behandlungskammer angeordnet. In diesem Fall ist die Temperiervorrichtung vorzugsweise ein Infrarot-Strahler und die Behandlungskammer weist ein Strahlungsfenster auf, durch welches die Infrarot-Strahlung von der Temperiervorrichtung zum Koppelelement gelangen kann. Alternativ ist die Temperiervorrichtung ein Induktor, wobei die Behandlungskammer für das magnetische Wechselfeld angepasst sein kann. Vorteilhaft wird dabei die elektrische Entkopplung zwischen der Temperiervorrichtung und der Elektrode durch den Abstand zwischen der Temperiervorrichtung und dem Koppelelement und die dazwischen befindliche Luft bzw. ggf. das dazwischen befindliche Vakuum, welche als Dielektrikum wirken, erreicht.

Selbstverständlich kann auch das Koppelelement des ersten Systems, dessen Temperiervorrichtung außerhalb der Behandlungskammer angeordnet ist, vollständig oder teilweise außerhalb der Behandlungskammer angeordnet sein. Entsprechende Durchführungen durch eine Wandung der Behandlungskammer sind dem Fachmann bekannt.

Vorzugsweise weist die Behandlungsanlage mehrere Elektroden und mehrere Systeme zur Temperierung einer Elektrode auf, wobei die Koppelelemente von mindestens zwei Systemen zur Temperierung einer Elektrode über mindestens ein zusätzliches Wärmeleitrohr miteinander verbunden sind. Damit können Temperaturunterschiede zwischen den einzelnen Koppelelementen ausgeglichen und eine besonders homogene Temperaturverteilung über alle Elektroden, deren zugeordnete Koppelelemente miteinander über das zusätzliche Wärmeleitrohr verbunden sind, erreicht werden. Alternativ können selbstverständlich auch unterschiedliche Temperaturen für unterschiedliche Elektroden eingestellt werden, wobei die Koppelelemente dieser Elektroden dann nicht über ein zusätzliches Wärmeleitrohr miteinander verbunden sind.

Vorzugsweise weist die Behandlungsanlage mehrere Elektroden und mehrere Systeme zur Temperierung einer Elektrode auf, wobei die Nutzflächen der Elektroden jeweils parallel zueinander und sich gegenüberliegend angeordnet sind. Dies entspricht einem Stapel von Elektroden, wobei die Elektroden dabei vertikal übereinander oder horizontal nebeneinander oder entlang einer beliebigen anderen Raumrichtung nebeneinander angeordnet sein können. Benachbarte Elektroden sind dabei so mit einer oder mehreren Spannungsversorgungen verbunden, dass sie mit unterschiedlichen Elektrodenspannungen beaufschlagt werden können. Damit bilden benachbarte Elektroden jeweils einen (Platten-)Kondensator, in dem bspw. ein Plasma gezündet werden oder eine andere Behandlung vorgenommen werden kann. Vorzugsweise sind dabei Elektroden mit einer ersten Elektrodenspannung und Elektroden mit einer zweiten Elektrodenspannung, die von der ersten Elektrodenspannung verschieden ist, alternierend im Stapel angeordnet. Jeder Elektrode ist ein individuelles System zur Temperierung der Elektrode zugeordnet, wobei jedes Koppelelement genau einer Elektrode zugeordnet ist. Die Koppelelemente der Systeme zur Temperierung der Elektroden sind jeweils ein von der Elektrode getrennter Körper wie dies in Bezug auf die zweite oder dritte Ausführungsform des erfindungsgemäßen Systems oben beschrieben ist. Dabei weist jedes Koppelelement an mindestens einer seiner Außenflächen dasselbe Potential wie die zugeordnete Elektrode auf. Mit anderen Worten, die Elektrode und das Koppelelement sind elektrisch gekoppelt und liegen auf demselben Potential. Um die Kapazität der zusätzlich ausgebildeten (Platten-)Kondensatoren zwischen den Koppelelementen benachbarter Elektroden zu verringern und somit die Gefahr einer Zündung eines parasitären Plasmas zu minimieren, sind die Koppelelemente, welche benachbarten Elektroden zugeordnet sind, in mindestens einer Richtung senkrecht zum Abstand der benachbarten Elektroden versetzt zueinander angeordnet. Das heißt, dass die Koppelelemente entweder auf verschiedenen Seiten der Elektroden angeordnet sind, vorzugsweise auf sich gegenüberliegenden Seiten der Elektroden, oder dass die Koppelelemente, die sich dann nur über einen Teil einer der seitlichen Ausdehnung der Elektrode erstrecken, zwar auf der gleichen Seite der Elektroden angeordnet sind, dabei jedoch entlang dieser seitlichen Ausdehnung der Elektroden versetzt zueinander angeordnet sind, vorzugsweise ein Koppelelement am Beginn der seitlichen Ausdehnung der zugehörigen Elektrode und ein Koppelelement am Ende der seitlichen Ausdehnung der zugehörigen Elektrode, also an verschiedenen Rändern der seitlichen Ausdehnung.

In einer besonderen Ausführungsform der Behandlungsanlage ist das Koppelelement mindestens eines Systems zur Temperierung einer Elektrode mit einer Spannungsversorgung verbunden und ist allein oder zusammen mit dem jeweiligen mindestens einen Wärmeleitrohr geeignet, die zugeordnete Elektrode mit einer Elektrodenspannung zu beaufschlagen. Mit anderen Worten: ist das Koppelelement elektrisch leitfähig und grenzt an die Elektrode an oder ist auch das mindestens eine Wärmeleitrohr elektrisch leitfähig, so kann die Elektrode über das Koppelelement mit einer elektrischen Leistung versorgt werden. Damit kann eine separate Spannungszuführung an die Elektrode durch eine Spannungszuführung an das Koppelelement ersetzt werden, was positive Effekte in Bezug auf den Platzbedarf an der Elektrode und auf weitere Eigenschaften der Behandlungsanlage hat. Beispielsweise können die Anzahl der Vakuumdurchführungen reduziert und parasitäre Plasmen vermieden bzw. zusätzliche elektrische Isolierungen, die die Ausbildung parasitärer Plasmen bei einer separaten Spannungszuführung an die Elektrode(n) verhindern sollen, eingespart werden. Falls ein zusätzliches Wärmeleitrohr vorhanden ist, kann auch dieses zur Zuführung der Elektrodenspannung an die Koppelelemente genutzt werden.

Das erfindungsgemäße System und die erfindungsgemäße Behandlungsanlage haben folgende Vorteile:
- sehr homogene Temperaturverteilung innerhalb der Elektrode erreichbar (kleiner oder gleich 0,5 K Temperaturdifferenz),
- sehr schnelle Wärmeübertragung, insbesondere hohe Aufheizraten von 2 bis 3 K/s möglich,
- keine Beeinflussung eines Plasmaprozesses, bei dem die Elektrode zum Einsatz kommt, da alle Materialien des Systems prozesskompatibel auswählbar sind und durch die Wärmeleitrohre keine zusätzlichen elektromagnetischen Felder eingebracht werden,
- Vermeidung oder Minimierung von elektrischen Verlusten bei der Beaufschlagung der Elektrode mit einer elektrischen Leistung durch die zumindest weitgehende elektrische Entkopplung der Elektrode von der Temperiervorrichtung,
- Schutz der Temperiervorrichtung vor Schäden durch eine hochfrequente Elektrodenspannung durch die zumindest weitgehende elektrische Entkopplung der Elektrode von der Temperiervorrichtung, wobei keine Filterschaltung notwendig ist,
- kostengünstige und vielseitig gestaltbare Variante zur Temperierung der Elektrode, bei der auch eine Kühlung möglich ist,
- Minimierung der Leckgefahr durch Minimierung des Volumens von flüssigen oder gasförmigen Fremdstoffen in einer Behandlungskammer,
- Minimierung des Wartungsaufwandes der Behandlungskammer oder der gesamten Behandlungsanlage,
- Minimierung der Anzahl der notwendigen Vakuumdurchführungen durch Mehrfachfunktionen von Komponenten (z.B. Wärmeleitrohr zur Übertragung der Wärmemenge und zur Zuführung einer Spannung an die Elektrode).

Im Nachfolgenden soll die Erfindung anhand von Ausführungsbeispielen und Figuren verdeutlicht werden. Dabei sind die Abmessungen der einzelnen Elemente sowie deren Relation zueinander nicht maßstäblich, sondern nur schematisch wiedergegeben. Gleiche Bezugszeichen bezeichnen entsprechende gleichartige Bauteile.

Es zeigen:
- Fig. 1A: eine schematische Darstellung eines ersten Beispiels des erfindungsgemäßen Systems zur Temperierung einer Elektrode, bei dem die Temperiervorrichtung von dem Koppelelement beabstandet ist,
- Fig. 1B: eine schematische Darstellung eines zweiten Beispiels des erfindungsgemäßen Systems zur Temperierung einer Elektrode, bei dem die Temperiervorrichtung physisch mit dem Koppelelement verbunden ist,
- Fig. 2: eine perspektivische Darstellung eines Teils eines Beispiels für die erste Ausführungsform des erfindungsgemäßen Systems zur Temperierung einer Elektrode,
- Fig. 3A: eine perspektivische Darstellung eines Beispiels für die zweite Ausführungsform des erfindungsgemäßen Systems zur Temperierung einer Elektrode,
- Fig. 3B: einen Querschnitt durch das Beispiel aus Fig. 3A an einer ersten Position,
- Fig. 3C: einen Querschnitt durch das Beispiel aus Fig. 3A an einer zweiten Position,
- Fig. 4: eine perspektivische Darstellung eines Teils eines ersten Beispiels für die dritte Ausführungsform des erfindungsgemäßen Systems zur Temperierung einer Elektrode,
- Fig. 5A: eine perspektivische Darstellung eines Teils eines zweiten Beispiels für die dritte Ausführungsform des erfindungsgemäßen Systems zur Temperierung einer Elektrode,
- Fig. 5B: eine perspektivische Darstellung nur eines unteren Teils der in Fig. 5A dargestellten Komponenten,
- Fig. 6A: eine schematische Darstellung eines ersten Beispiels der erfindungsgemäßen Behandlungsanlage, bei der das Koppelelement eines Systems zur Temperierung einer Elektrode außerhalb der Behandlungskammer angeordnet ist,
- Fig. 6B: eine schematische Darstellung eines zweiten Beispiels der erfindungsgemäßen Behandlungsanlage, bei der das Koppelelement eines Systems zur Temperierung einer Elektrode innerhalb der Behandlungskammer und die Temperiervorrichtung außerhalb der Behandlungskammer angeordnet sind,
- Fig. 7: eine schematische Darstellung eines dritten Beispiels der erfindungsgemäßen Behandlungsanlage, in der mehrere Elektroden angeordnet sind,
- Fig. 8: eine schematische Darstellung eines vierten Beispiels der erfindungsgemäßen Behandlungsanlage, die einen Elektrodenstapel enthält, bei dem benachbarte Koppelelemente versetzt angeordnet sind und einige der Koppelelemente mit demselben elektrischen Potential über ein zusätzliches Wärmeleitrohr miteinander verbunden sind, und
- Fig. 9: eine schematische Darstellung eines fünften Beispiels der erfindungsgemäßen Behandlungsanlage, die einen Elektrodenstapel enthält, bei dem benachbarte Koppelelemente versetzt angeordnet sind und Koppelelemente mit demselben elektrischen Potential über eine gemeinsame Temperiervorrichtung temperiert werden.

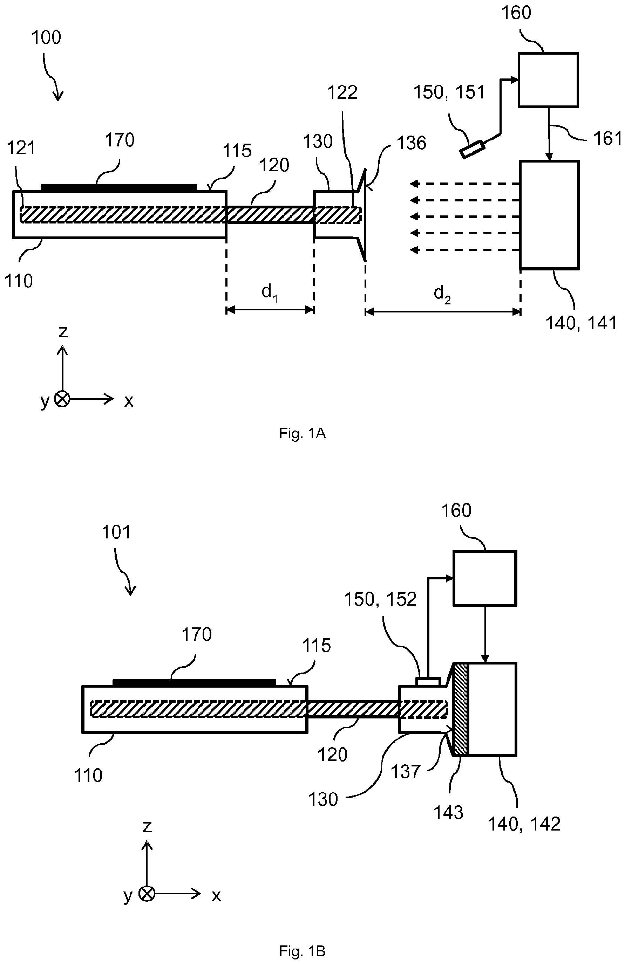

Mit Bezug auf die Figuren 1A und 1B wird der grundsätzliche Aufbau des erfindungsgemäßen Systems zur Temperierung einer Elektrode 1 dargestellt, wobei die Wärmekopplung der Temperiervorrichtung mit dem Koppelelement über Wärmestrahlung (Fig. 1A) oder über Wärmeleitung (Fig. 1B) erfolgt.

Figur 1A zeigt ein erstes Beispiel 100 des erfindungsgemäßen Systems. Es enthält mindestens ein Wärmeleitrohr 120 mit einem ersten Ende 121 und einem zweiten Ende 122, ein Koppelelement 130 und eine Temperiervorrichtung 140. Das erste Ende 121 des Wärmeleitrohrs 120 ist im Inneren der Elektrode 110 angeordnet, während das zweite Ende 122 des Wärmeleitrohrs 120 im dargestellten Beispiel 100 im Koppelelement 130 angeordnet ist. Das Wärmeleitrohr 120 verläuft zumindest teilweise mit seiner Längsausdehnung (zwischen dem ersten und dem zweiten Ende des Wärmeleitrohrs) parallel zu einer Nutzfläche 115 der Elektrode 110, auf der bspw. ein Substrat 170 angeordnet und gehalten oder gelagert ist. Es können auch mehrere Substrate auf der Nutzfläche 115 der Elektrode 110 angeordnet und gehalten oder gelagert werden. Die Nutzfläche 115 erstreckt sich im dargestellten Fall in einer x-y-Ebene. Im dargestellten Fall verläuft das Wärmeleitrohr 120 über seine gesamte Längsausdehnung parallel zur Nutzfläche 115, beispielsweise als gerades Wärmeleitrohr entlang der x-Richtung. Das Koppelelement 130 weist eine geschwärzte Wärmeübertragungsfläche 136 auf, die einen gegenüber anderen Bereichen des Koppelelements 130 erhöhten thermischen Absorptionsgrad aufweist und im Vergleich mit einer Außenfläche des Koppelelements 130, die der Wärmeübertragungsfläche 136 gegenüberliegt, und im Vergleich mit einer Außenfläche der Elektrode 110, die dem Koppelelement 130 gegenüberliegt, eine größere Fläche aufweist. Dazu ist im dargestellten Fall die Ausdehnung der Wärmeübertragungsfläche 136 entlang der z-Richtung vergrößert. Die Wärmeübertragungsfläche 136 ist so besonders gut zur Absorption einer Wärmestrahlung (in Fig. 1A durch die gestrichelten Pfeile dargestellt), welche von der Temperiervorrichtung 140, welche hierbei ein Infrarotstrahler 141 ist, geeignet. Das zweite Ende 122 des Wärmeleitrohrs 120 grenzt nicht an die Wärmeübertragungsfläche 136 an, kann jedoch in anderen Beispielen auch an die Wärmeübertragungsfläche angrenzen.

Die Temperiervorrichtung 140 kann auch ein Induktor sein, der das Koppelelement 130 durch induzierte Wirbelströme erwärmt. In diesem Fall weist das Koppelelement keine gesonderte Wärmeübertragungsfläche auf.

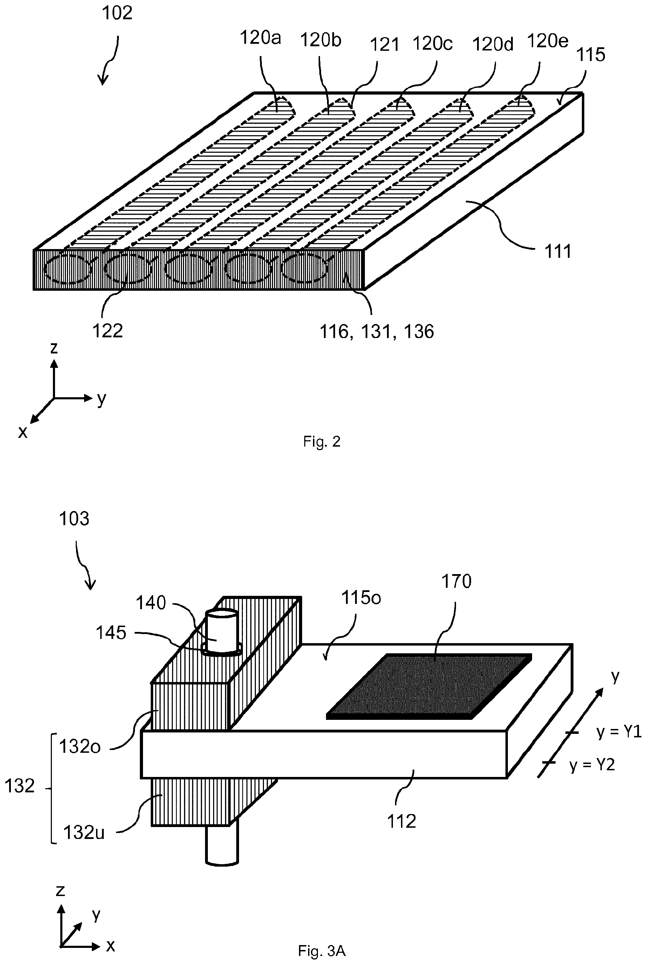

Im ersten Beispiel 100 des erfindungsgemäßen Systems ist das Koppelelement 130 ein gegenüber der Elektrode 110 eigenständiger Körper und von dieser beabstandet angeordnet, wobei die Entfernung von sich gegenüberliegenden Außenflächen der Elektrode 110 und des Koppelelements 130 als Abstand d₁ in Fig. 1A dargestellt ist. Der Abstand d₁ liegt im Bereich von 0 mm bis 100 mm, wobei der Abstand d₁ durch die maximale Länge des oder der Wärmeleitrohre 120 begrenzt wird. Bei kleinen Durchmessern derzeit verfügbarer Wärmeleitrohre 120 liegt die maximale Länge bei ca. 1 m. Jedoch kann das Koppelelement auch als Außenfläche der Elektrode ausgebildet sein, wie dies mit Bezug auf Fig. 2 näher erläutert wird. Darüber hinaus sind das Koppelelement 130 und die Temperiervorrichtung 140 ebenfalls voneinander mit einem Abstand d₂ angeordnet, wobei sich zwischen dem Koppelelement 130 und der Temperiervorrichtung 140 Luft und/oder Vakuum befindet. Der Abstand d₂ liegt im Bereich von 1 mm bis 50 mm. Dabei wird der minimale Wert des Abstandes d₂ vor allem von der Größe der Wärmeübertragungsfläche 136 bestimmt, da eine geringe kapazitive Kopplung zwischen der Temperiervorrichtung 140 und dem Koppelelement 130 im Bereich von wenigen pF gewährleistet sein soll. Der maximale Wert des Abstandes d₂ hängt dagegen vor allem von der Fokussierbarkeit und/oder Leistungsfähigkeit der Temperiervorrichtung 140 ab und kann damit auch größer als der angegebene Wert sein. Damit können das Wärmeleitrohr 120 und/oder das Koppelelement 130 elektrisch leitend oder elektrisch isolierend ausgeführt sein.

Das erste Beispiel 100 des erfindungsgemäßen Systems weist darüber hinaus eine Temperaturmesseinheit 150 und eine Steuereinheit 160 auf. Die Temperaturmesseinheit 150 misst die Temperatur des Koppelelements 130 oder andere Parameter, welche Rückschlüsse auf die Temperatur des Koppelelements 130 erlauben, und überträgt den oder die gemessenen Parameter oder die daraus ermittelte Temperatur drahtgebunden oder drahtlos an die Steuereinheit 160. Die Temperaturmesseinheit 150 ist im dargestellten Fall als Pyrometer 151 ausgeführt, welches die Temperatur des Koppelelements 130 mit Hilfe der über die Wärmeübertragungsfläche 136 abgegebene Strahlung ermittelt. Die Steuereinheit 160 steuert über eine Steuerleitung 161, welche auch eine drahtlose Verbindung sein kann, die Temperiervorrichtung 140 derart, dass eine gewünschte Temperatur des Koppelelements 130 erreicht wird.

Das zweite Bespiel 101 des erfindungsgemäßen Systems, welches in Fig. 1B dargestellt ist, unterscheidet sich von dem ersten Beispiel 100 aus Fig. 1A durch die folgenden Punkte:
- Das Koppelelement 130 weist nun eine hochwärmeleitfähige Wärmeübertragungsfläche 137 statt der geschwärzten Wärmeübertragungsfläche des ersten Beispiels 100 auf.
- Die Temperiervorrichtung 140 ist ein resistiver Heizer 142 (oder eine fluidbasierte Temperiervorrichtung) und ist physisch mit der Wärmeübertragungsfläche 137 des Koppelelements 130 über einen elektrischen Isolator 143 verbunden. Der elektrische Isolator 143 kann bspw. aus einer Oxidkeramik, z.B. Al₂O₃, oder einer Nichtoxidkeramik, z.B. AIN, bestehen. Wenn das Wärmeleitrohr 120 und/oder das Koppelelement 130 elektrisch isolierend ausgeführt sind, kann der elektrische Isolator 143 auch wegfallen und die Temperiervorrichtung 140 direkt an die Wärmeübertragungsfläche 137 des Koppelelements 130 angrenzen. Auch der elektrische Isolator 143 weist eine hohe Wärmeleitfähigkeit von größer oder gleich 20 W/(m•K), vorzugsweise jedoch über 150 W/(m•K), auf.
- Die Temperaturmesseinheit 150 besteht aus einem Thermoelement 152, welches auf einer Oberfläche des Koppelelements 130 angeordnet ist, wobei es gegebenenfalls elektrisch vom Koppelelement 130 durch einen Isolator entkoppelt ist. Das Thermoelement 152 misst einen mit der Temperatur des Koppelelements 130 verknüpften Parameter und übermittelt diesen oder die ermittelte Temperatur drahtgebunden oder drahtlos an die Steuereinheit 160.

Figur 2 zeigt einen Teil eines Beispiels 102 für die erste Ausführungsform des erfindungsgemäßen Systems zur Temperierung einer Elektrode 111 in einer perspektivischen Darstellung. Die Elektrode 111 enthält fünf Wärmeleitrohre 120a bis 120e und weist eine Nutzfläche 115 und eine Seitenfläche 116 auf. Die Seitenfläche 116 bildet gleichzeitig das Koppelelement 131 der ersten Ausführungsform 102. Die Temperiervorrichtung und weitere Elemente des erfindungsgemäßen Systems sind in Fig. 2 nicht dargestellt.

Das Koppelelement 131 ist als geschwärzte Wärmeübertragungsfläche 136 ausgeführt. Die zweiten Enden 122 der Wärmeleitrohre 120a bis 120e grenzen alle an die Seitenfläche 116 der Elektrode 111 an, während die ersten Enden 121 der Wärmeleitrohre 120a bis 120e nahe der der Seitenfläche 116 gegenüberliegenden Seitenfläche der Elektrode 111 angeordnet sind, jedoch nicht an diese angrenzen. Die Wärmeleitrohre 120a bis 120e sind als gerade Rohre mit einem ovalen Querschnitt ausgebildet und erstrecken sich im Inneren der Elektrode 111 parallel zur Nutzfläche 115. Da sie von außen nicht sichtbar sind, sind ihre Umrisse in Figur 2 nur gestrichelt dargestellt. Selbstverständlich können die Wärmeleitrohre auch andere Querschnitte aufweisen, bspw. kreisrunde oder flache. Darüber hinaus können die Wärmeleitrohre auch nichtregelmäßige Querschnitte oder lokal verschiedene Querschnitte aufweisen, wenn sie bspw. bei der Montage in der Elektrode leicht abgeflacht oder verformt werden.

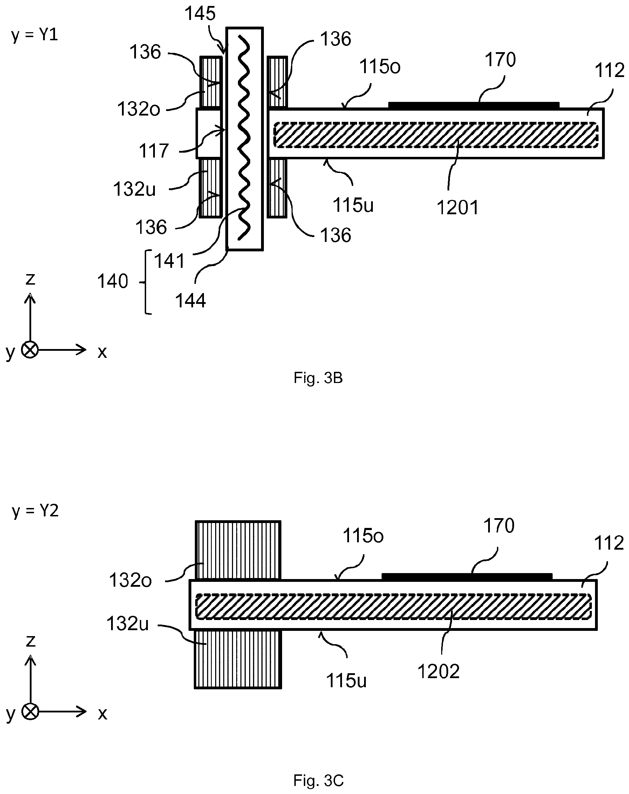

Mit Bezug auf die Figuren 3A bis 3C wird ein Beispiel 103 für die zweite Ausführungsform des erfindungsgemäßen Systems zur Temperierung einer Elektrode 112 erläutert. Dabei zeigt die Figur 3A eine schematische perspektivische Ansicht des Systems 103, während die Figuren 3B und 3C jeweils einen schematischen Querschnitt durch das System 103 aus Fig. 3A an den Positionen Y1 bzw. Y2 zeigen.

Das System 103 enthält Wärmerohre 1201 und 1202, welche in der Elektrode 112 angeordnet sind, und ein Koppelelement 132, welches gegenüber der Elektrode 112 eigenständiger Körper und nicht direkt mit den Wärmerohren 1201 und 1202 verbunden ist. Das Koppelelement 132 besteht aus einem Oberteil 132o, welches an die obere Nutzfläche 115o der Elektrode 112 angrenzt, und ein Unterteil 132u, welches an die untere Nutzfläche 115u der Elektrode 112 angrenzt. Dabei kann auf der oberen Nutzfläche 115o in einem Bereich, in dem das Koppelelement 132 nicht angeordnet ist, ein Substrat 170 angeordnet und gehalten werden, wie dies in den Figuren 3A bis 3C dargestellt ist. Die untere Nutzfläche 115u ist im dargestellten Bespiel des Systems 103 nicht genutzt, kann aber bspw. einen Gasverteiler zur Zuführung eines Prozessgases in einen Prozessraum, welcher unterhalb der unteren Nutzfläche 115u entlang der z-Richtung angeordnet ist, enthalten. Selbstverständlich kann das Koppelelement 132 aber auch nur auf einer der Oberflächen der Elektrode 112 angeordnet sein, d.h. bspw. nur aus dem Oberteil 132o bestehen.

Das System 103 enthält weiterhin eine Temperiervorrichtung 140, welche im dargestellten Beispiel ein Infrarotstrahler 141 ist, der in einem Hüllrohr 144, bspw. aus Quarzglas, angeordnet ist. In dem Hüllrohr 144 kann eine Atmosphäre, welche von einer Prozessatmosphäre, die während der Behandlung des Substrates 170 erzeugt wird, verschieden ist, vorliegen. Bspw. kann die Atmosphäre im Hüllrohr 144 Luft bei Normaldruck (10⁵ Pa) sein, während die Prozessatmosphäre ein Gemisch aus Silan (SiH₄) und Wasserstoff (H₂) bei einem Druck von 100 Pa ist. Dies hat den Vorteil, dass der Infrarot-Strahler 141 von der Prozessatmosphäre abgeschirmt ist und bei idealen Umgebungsbedingungen betrieben werden kann. Dabei kann der Infrarot-Strahler 141 über seine gesamte Länge (entlang der z-Richtung in den Figuren) gleichförmig ausgebildet sein oder verschiedene Bereiche entlang seiner Länge aufweisen, wobei die verschiedenen Bereiche unterschiedliche Wärmemengen abstrahlen.

Die Temperiervorrichtung 140 ist in einer Öffnung 145 des Koppelelements 132 und in einer Öffnung 117 der Elektrode 112 angeordnet. Dabei erstrecken sich beide Öffnungen 144 und 117 jeweils durch das gesamte Koppelelement 132 bzw. die gesamte Elektrode 112 hindurch, so dass die Temperiervorrichtung 140 sowohl aus dem Oberteil 132o des Koppelelements 132 als auch aus dem Unterteil 132u des Koppelelements 132 hinausragt. Jedoch kann die Temperiervorrichtung 140 bspw. auch innerhalb des Koppelelements 132, bspw. innerhalb des Oberteils 132o, enden, so dass die Öffnung 145 des Koppelelements 132 nicht bis zur Oberfläche des Oberteils 132o reicht. Das Hüllrohr 144 hat bspw. einen kreisrunden Querschnitt mit einem Durchmesser von 32 mm. Das Hüllrohr 144 ist von dem Koppelelement 132 und der Elektrode 112 durch einen Spalt mit einer Breite von bspw. 0,5 mm bis 5 mm beabstandet, um eine thermische Ausdehnung des Hüllrohres 144, des Koppelelements 132 und der Elektrode 112 zu ermöglichen. Die Innenflächen der Öffnung 145 des Koppelelements 132, welche Außenflächen des Koppelelements 132 sind, bilden die Wärmeübertragungsfläche des Koppelelements 132 und können bspw. als geschwärzte Wärmeübertragungsfläche 136 ausgestaltet sein, um die Wärmestrahlung besonders gut aufzunehmen. Das heißt, die Wärmeübertragungsfläche 136 weist ein gegenüber den anderen Bereichen des Koppelelements 132 erhöhtes Absorptionsvermögen auf. Das Koppelelement besteht bspw. aus Aluminium, kann aber auch aus einem elektrisch nichtleitenden Material bestehen.

Die Wärmerohre 1201 und 1202 sind innerhalb der Elektrode 112 angeordnet, wobei beide Enden der Wärmerohre 1201 und 1202 innerhalb der Elektrode 112 liegen. Das oder die Wärmerohre 1201 sind in einem Bereich der Elektrode 112 entlang der y-Richtung angeordnet, in dem auch die Öffnung 117 in der Elektrode 112 ausgebildet ist, wie dies in Fig. 3B dargestellt ist. Demgegenüber sind die Wärmerohre 1202 in Bereichen der Elektrode 112 entlang der y-Richtung angeordnet, in dem keine Öffnung 117 in der Elektrode 112 ausgebildet ist, was in Fig. 3C dargestellt ist. Das oder die Wärmerohre 1201 weisen eine geringere Länge entlang der x-Richtung auf als die Wärmerohre 1202. Die Wärmerohre 1201 und 1202 sind vollständig von dem Koppelelement 132 beabstandet, d.h. sie grenzen weder an dieses an, noch ist ein Ende der Wärmerohre 1201 und 1202 innerhalb des Koppelelements 132 angeordnet. Damit wird die Wärmemenge von der Temperiervorrichtung 140 an die Wärmerohre 1201 und 1202 oder umgekehrt über das Material der Elektrode 112 übertragen, wobei die Temperiervorrichtung 140 sowohl die Elektrode 112 direkt als auch indirekt über das Koppelelement 132 temperiert. Dabei ist die Wärmeübertragung vom Koppelelement 132 auf die Elektrode 112 aufgrund der größeren Koppelfläche (Grenzfläche zwischen Koppelelement 132 und Elektrode 112) und der besseren Wärmeleitfähigkeit des Koppelelements 132 im Vergleich zu der Elektrode 112 wesentlich größer als die Wärmeübertragung von der Temperiervorrichtung 140 direkt an die Elektrode 112. Das Koppelelement 132 erstreckt sich insgesamt über eine wesentlich größere Länge entlang der Temperiervorrichtung 140 (in z-Richtung) als die Elektrode 112. Bspw. beträgt die Summe der Dicken des Oberteils 132o und des Unterteils 132u des Koppelelements 132 entlang der z-Richtung 38 mm, während die Elektrode 112 nur eine Dicke von 12 mm entlang der z-Richtung aufweist. Die Koppelfläche zwischen dem Koppelelement 132 und der Elektrode 112 in einer x-y-Ebene beträgt bspw. 100 cm², was bspw. weniger als 15% der Nutzfläche der Elektrode 112 entspricht.

Selbstverständlich können mehr als eine Temperiervorrichtung 140 in Öffnungen 145 und 117 angeordnet sein, bspw. zwei oder drei Temperiervorrichtungen, wobei diese auch unterschiedliche Wärmemengen an das Koppelelement 132 übertragen können. Darüber hinaus ist es auch möglich, dass die Temperiervorrichtung 140 ein resistiver Heizer oder eine fluidbasierte Vorrichtung ist, wobei eine entsprechende elektrische Isolation zwischen der Elektrode 112 und der Temperiervorrichtung 140 und ggf. auch zwischen dem Koppelelement 132 und der Temperiervorrichtung 140 vorgesehen ist. Darüber hinaus kann das Koppelelement 132 auch weitere Elemente, wie bspw. eine Gaszuführung oder einen elektrischen Anschluss zur Zuführung eines Potentials an die Elektrode 112 aufweisen.

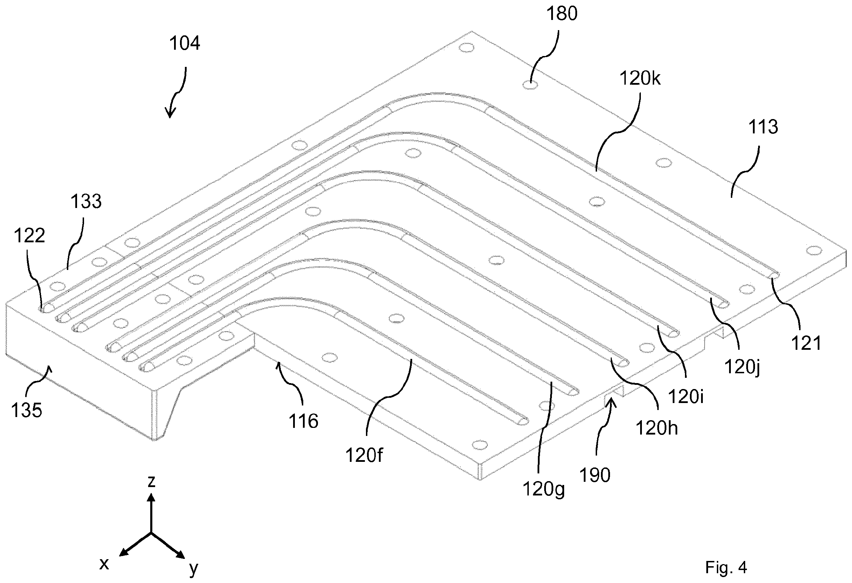

Figur 4 zeigt einen Teil eines ersten Beispiels 104 für die dritte Ausführungsform des erfindungsgemäßen Systems zur Temperierung einer Elektrode 113, wobei die Temperiervorrichtung nicht dargestellt ist. Auch die dritte Ausführungsform des erfindungsgemäßen Systems ist dadurch gekennzeichnet, dass ein Koppelelement als eigenständiger Körper ausgebildet ist. Im ersten Beispiel 103 grenzt das Koppelelement 133 an eine Seitenfläche 116 der Elektrode 113 an. Fig. 4 zeigt von der Elektrode 113 sowie dem Koppelelement 133 jeweils nur eine Unterseite, in denen Wärmeleitrohre 120f bis 120k angeordnet sind. Beispielhaft sind für das Wärmeleitrohr 120k das erste Ende 121 und das zweite Ende 122 bezeichnet. Alle Wärmeleitrohre 120f bis 120k sind als gebogene Rohre mit einem kreisrunden Querschnitt ausgeführt, die sich zunächst entlang der x-Richtung von dem Koppelelement 133 in der Elektrode 113 erstrecken und sich dann im weiteren Verlauf entlang der y-Richtung erstrecken. Durch diese Biegung können die Wärmeleitrohre 120f bis 120k gleichmäßig die Elektrode 113 in ihrer gesamten Ausdehnung entlang der x-y-Ebene temperieren, während gleichzeitig das Koppelelement 133 eine wesentlich geringere Ausdehnung in Bezug auf die y-Richtung aufweist als die Elektrode 113. Um eine gute Wärmeeinkopplung von einer Temperiervorrichtung zu erreichen, weist das Koppelelement 133 eine Wärmeübertragungsfläche 135 auf, die bspw. eine geschwärzte Wärmeübertragungsfläche oder eine hochwärmeleitfähige Wärmeübertragungsfläche, wie dies mit Bezug auf die Figuren 1A und 1B erläutert wurde, sein kann. Die Wärmeübertragungsfläche 135 weist gegenüber der Seitenfläche 116 der Elektrode 113 eine größere Ausdehnung entlang der z-Richtung auf.

Wie bereits erwähnt, ist in Fig. 4 nur eine Unterseite der Elektrode 113 und eine Unterseite des Koppelelements 133 dargestellt, in denen in dafür vorgesehenen Vertiefungen in der Elektrode 113 bzw. im Koppelelement 133 die Wärmeleitrohre 120f bis 120k angeordnet sind. Dabei sind die Vertiefungen vorzugsweise so bemessen, dass die Wärmeleitrohre 120f bis 120k fast vollständig in der Unterseite der Elektrode 113 bzw. der Unterseite des Koppelelements 133 aufgenommen werden. So sind die Vertiefungen für die Wärmeleitrohre 120f bis 120k beispielsweise geringfügig weniger tief als die Höhe der Wärmeleitrohre, so dass die Wärmeleitrohre bei einer Montage der Oberseiten der Elektrode 113 bzw. des Koppelelements 133 auf die Unterseiten der Elektrode 113 bzw. des Koppelelements 133 leicht gestaucht werden. Damit kann ein sehr guter Wärmekontakt zwischen den Wärmeleitrohren 120f bis 120k und der Elektrode 113 bzw. dem Koppelelement 133 ohne weitere Hilfsmittel, wie Löt- oder Wärmeleitpasten, erreicht werden. Jedoch ist es auch möglich, dass sich die Wärmeleitrohre 120f bis 120k bis etwa zur Hälfte ihrer Ausdehnung entlang der z-Richtung von der Unterseite der Elektrode 113 bzw. der Unterseite des Koppelelements 133 aufgenommen werden. Die Oberseiten der Elektrode 113 bzw. des Koppelelements 133 weisen dann jeweils ebenfalls entsprechende Vertiefungen auf, so dass die Wärmeleitrohre 120f bis 120k nach der Verbindung der jeweiligen Ober- und Unterseiten der Elektrode 113 und des Koppelelements 133 vollständig von dem Material der Elektrode 113 bzw. des Koppelelements 133 umgeben sind. Zur Verbindung der Ober- und der Unterseite der Elektrode 113 bzw. des Koppelelements 133 weisen die Elektrode 113 und das Koppelelement 133 Befestigungslöcher 180 auf, welche Durchgangslöcher oder im Material der Elektrode 113 bzw. des Koppelelements 133 endende Löcher sein können und in welche Befestigungsmittel, bspw. Schrauben, Nieten oder ähnliches eingebracht werden können.

In der Unterseite der Elektrode 113 ist eine Halterungsöffnung 190, bspw. für eine Bewegungseinrichtung zur Bewegung oder Halterung der Elektrode 113, ausgebildet, während eine äußere Oberfläche der Oberseite der Elektrode 113, welche sich in einer x-y-Ebene erstreckt, zur Aufnahme und Halterung eines Substrats dient.

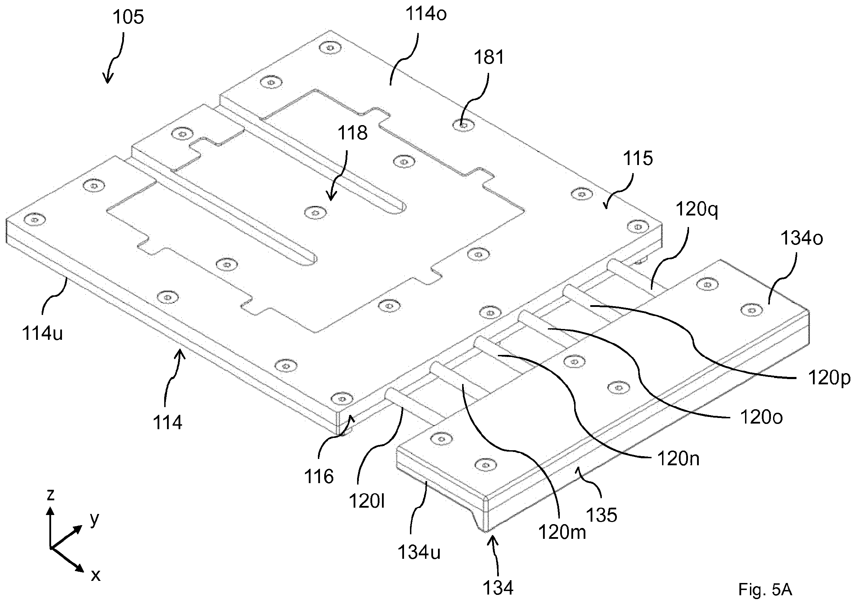

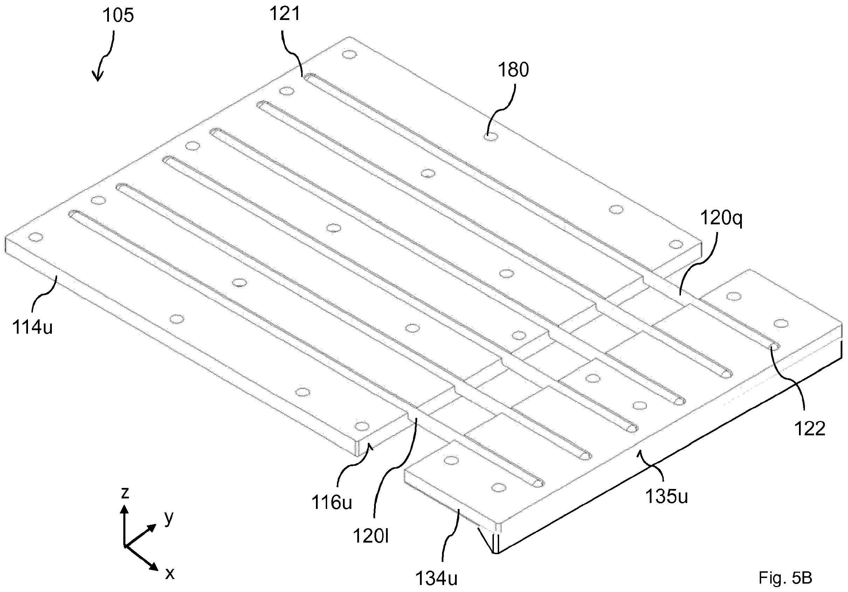

Die Figuren 5A und 5B sind perspektivische Darstellungen eines Teils eines zweiten Beispiels 105 für die dritte Ausführungsform des erfindungsgemäßen Systems, wobei Fig. 5B nur den unteren Teil der in Fig. 5A dargestellten Komponenten zeigt. Die Temperiervorrichtung und gegebenenfalls weitere Komponenten des erfindungsgemäßen Systems sind nicht dargestellt.

Die Elektrode 114 und das Koppelelement 134 bestehen wiederum jeweils aus einem Oberteil 114o bzw. 134o und einem Unterteil 114u bzw. 134u, die jeweils Vertiefungen aufweisen, in denen Wärmeleitrohre 120l bis 120q angeordnet sind. Im Gegensatz zu dem in Fig. 4 dargestellten ersten Beispiel 104 erstrecken sich die Wärmeleitrohre 120l bis 120q geradlinig entlang der x-Richtung und weisen keine Biegungen auf. Darüber hinaus erstreckt sich das Koppelelement 134 über die gesamte Ausdehnung der Seitenfläche 116 der Elektrode 114 entlang der y-Richtung, so dass das Koppelelement 134 und die Elektrode 114 dieselbe Ausdehnung entlang der y-Richtung aufweisen, und ist von der Seitenfläche 116 beabstandet. Die Wärmeleitrohre 120l bis 120q sind gleichmäßig über die Ausdehnung der Elektrode 114 und des Koppelelements 134 entlang der y-Richtung verteilt angeordnet. Jedoch können auch andere Verteilungen vorteilhaft sein, um gegebenenfalls große Wärmeabgaben der Elektrode 114 an ihren Seitenflächen auszugleichen oder andere spezifische Wärmeverteilungen über die Ausdehnung der Elektrode 114 zu erreichen. Das Koppelelement 134 weist wieder eine Wärmeübertragungsfläche 135 auf, die gegenüber der Seitenfläche 116 der Elektrode 114 in z-Richtung vergrößert ist.

Figur 5A zeigt die Elektrode 114 und das Koppelelement 134 in einem Einsatzzustand, wobei die Ober- und die Unterteile 114o und 114u bzw. 134o und 134u miteinander durch Befestigungsmittel 181 (bspw. Schrauben), die in Befestigungslöcher 180 (dargestellt in Fig. 5B) eingebracht sind, fest, aber lösbar verbunden sind. Demgegenüber zeigt die Fig. 5B lediglich das Unterteil 114u der Elektrode 114 mit dem Unterteil 116u der Seitenfläche 116 und das Unterteil 134u des Koppelelements 134 mit dem Unterteil 135u der Wärmeübertragungsfläche 135.

Darüber hinaus ist in Fig. 5A zu sehen, dass in der Nutzfläche 115 der Elektrode 114 eine Vertiefung 118 zur Aufnahme eines Substrathalters oder eines Substrats ausgebildet ist.

Des Weiteren ist es auch möglich, die Temperiervorrichtung 140 durch eine Öffnung im Koppelelement 133 bzw. 134 hindurchzuführen, wie dies mit Bezug auf die Figuren 3A bis 3C erläutert wurde, und damit das Koppelelement 133 bzw. 134 "von innen heraus" zu temperieren.

Obwohl in den Figuren bisher immer genau ein Koppelelement für eine Elektrode dargestellt ist, können auch mehrere Koppelelemente mit den dazugehörigen Wärmeleitrohren zur Temperierung einer Elektrode eingesetzt werden. Mit anderen Worten: Es können auch mehrere Systeme zur Temperierung einer Elektrode in einer Elektrode eingesetzt werden, wobei bspw. die Temperiervorrichtung von einigen oder allen der mehreren Systeme auch eine gemeinsame Temperiervorrichtung sein kann. In letztem Fall können durch unterschiedliche Ausgestaltungen der Koppelelemente oder der Wärmeleitrohre verschiedene Wärmemengen in verschiedene Bereiche der Elektrode eingebracht werden. Mehrere Systeme zur Temperierung einer Elektrode können bspw. zur Temperierung nur einer Elektrode eingesetzt werden, wenn unterschiedliche Bereiche der Elektrode unterschiedlich temperiert werden sollen. Im Allgemeinen sorgt jedoch die hohe Wärmeleitfähigkeit der meisten Elektrodenmaterialien für eine homogene Temperierung aller Bereiche der Elektrode auch bei geringfügig unterschiedlichem Wärmeeintrag.

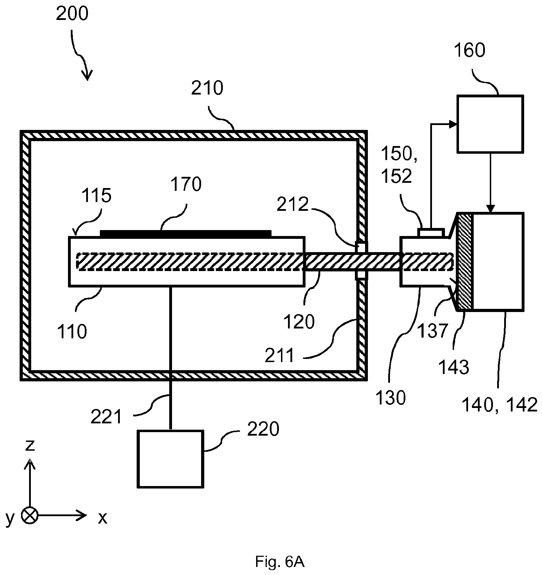

Figur 6A zeigt eine schematische Darstellung eines ersten Beispiels 200 der erfindungsgemäßen Behandlungsanlage. Die Behandlungsanlage 200 weist eine Behandlungskammer 210 auf, in der mindestens eine Elektrode 110 angeordnet ist. Die Elektrode 110 wird mittels eines erfindungsgemäßen Systems zur Temperierung geheizt oder gekühlt. Dazu weist das System zur Temperierung mindestens ein Wärmeleitrohr 120, ein Koppelelement 130 und eine Temperiervorrichtung 140 auf, wie dies mit Bezug auf die Fig. 1B beschrieben wurde. Auch eine Temperaturmesseinheit 150 und eine Steuereinheit 160 sind vorhanden. Das Koppelelement 130 und die Temperiervorrichtung 140 sind im ersten Beispiel 200 außerhalb der Behandlungskammer 210 angeordnet. Daher weist eine Wand 211 der Behandlungskammer 210, welche das Innere der Behandlungskammer 210 von ihrer Umgebung abgrenzt, eine Durchführung 212 für das Wärmeleitrohr 120 auf, welche eine thermische Isolation des Wärmeleitrohrs 120 von der Wand 211 und gegebenenfalls auch eine elektrische Isolation des Wärmeleitrohrs 120 von der Wand 211 gewährleistet. Auf der Nutzfläche 115 der Elektrode 110 ist ein Substrat 170, welches nicht zur Behandlungsanlage 200 gehört, angeordnet und kann mittels eines in der Behandlungskammer 210 ausgeführten Prozesses behandelt werden. Dazu kann die Elektrode 110 von einer elektrischen Spannungsversorgung 220 über eine elektrische Zuleitung 221 mit einer definierten Elektrodenspannung beaufschlagt. Die Spannung kann auch kontaktlos übertragen werden. Weitere Elemente der Behandlungsanlage 200, wie Vakuumpumpen und Gaszuleitungen, sind hier nicht dargestellt.

Das in Fig. 6A dargestellte erste Beispiel 200 ermöglicht den Einsatz einer Temperiervorrichtung 140, welche einen Wärmeeintrag in das Koppelelement 130 durch Wärmeleitung erreicht, bspw. der resistive Heizer 142 (wie dargestellt) oder eine fluidbasierte Temperiervorrichtung. Dabei können die Auswirkungen eines Lecks der fluidbasierten Temperiervorrichtung durch die Verlegung der Temperiervorrichtung aus der Behandlungskammer 210 heraus verringert werden. Selbstverständlich ist aber auch die Nutzung einer Strahlungsquelle als Temperiervorrichtung möglich.

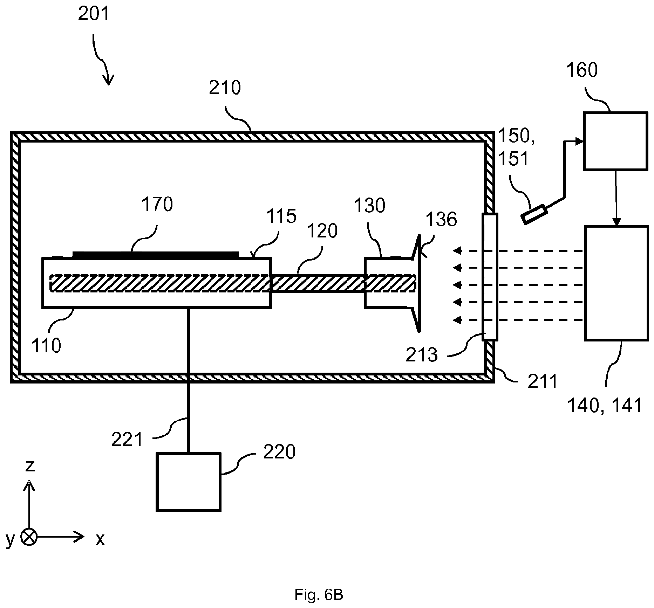

Figur 6B zeigt eine schematische Darstellung eines zweiten Beispiels 201 der erfindungsgemäßen Behandlungsanlage. Dabei weist die Behandlungsanlage 201 prinzipiell dieselben Komponenten wie die Behandlungsanlage 200 auf, nämlich eine Elektrode 110, ein Wärmeleitrohr 120, ein Koppelelement 130, eine Temperiervorrichtung 140, eine Temperaturmesseinheit 150, eine Steuereinheit 160, eine Behandlungskammer 210 mit einer Wand 211, eine elektrische Spannungsversorgung 220 und eine elektrische Zuleitung 221. Jedoch ist nun das Koppelelement 130 innerhalb der Behandlungskammer 210 angeordnet, während die Temperiervorrichtung 140 weiterhin außerhalb der Behandlungskammer 210 angeordnet ist. Dies ist besonders für den Einsatz eines Infrarot-Strahlers 141 (wie dargestellt) oder einer induktiven Einrichtung als Temperiervorrichtung 140 geeignet, wie dies mit Bezug auf die Fig. 1A beschrieben ist. Im Strahlungsweg zwischen der Temperiervorrichtung 140 und dem Koppelelement 130 ist ein Strahlungsfenster 213, z.B. aus Quarzglas, in der Wand 211 der Behandlungskammer 210 angeordnet.

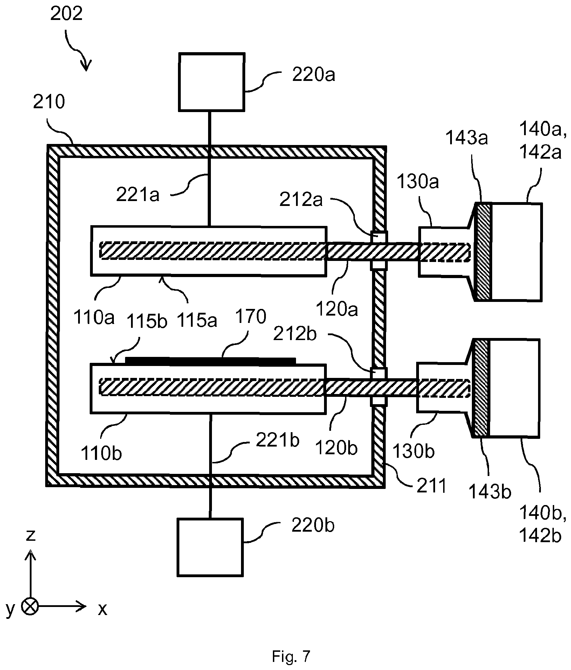

Figur 7 stellt schematisch ein drittes Beispiel 202 der erfindungsgemäßen Behandlungsanlage dar, bei der mehrere Elektroden in der Behandlungskammer angeordnet sind. Im Beispiel 202 sind zwei Elektroden 110a und 110b in der Behandlungskammer 210 angeordnet, wobei die Nutzflächen 115a und 115b der Elektroden 110a und 110b parallel zueinander und einander gegenüberliegend angeordnet sind. Damit bilden die beiden Elektroden 110a und 110b einen Plattenkondensator, der bei entsprechender Potentialbeaufschlagung bspw. die Zündung eines Plasmas zwischen den Elektroden 110a und 110b ermöglicht. Dazu sind die Elektroden 110a und 110b jeweils über separate elektrische Zuleitungen 221a bzw. 221b mit jeweils einer separaten elektrischen Spannungsversorgung 220a bzw. 220b verbunden. Selbstverständlich können auch beide Elektroden 110a und 110b von nur einer elektrischen Spannungsversorgung mit unterschiedlichen Potentialen beaufschlagt werden.

Wie in Fig. 7 dargestellt, kann dabei nur eine Elektrode, bspw. die Elektrode 110b, ein oder mehrere Substrate halten, während die andere Elektrode, bspw. die Elektrode 110a, nur zur Erzeugung eines definierten elektrischen Feldes dient. Jedoch können auch beide Elektroden ein oder mehrere Substrate halten oder eine oder beide Elektroden können weitere Funktionen, wie bspw. die Funktion einer Gaszuführung, ausüben.

Jede Elektrode 110a und 110b wird über ein separates System zur Temperierung der jeweiligen Elektrode geheizt oder gekühlt. Dazu überträgt ein erstes Wärmeleitrohr 120a eine erste Wärmemenge zwischen einem ersten Koppelelement 130a und der ersten Elektrode 110a, wobei das erste Koppelelement 130a durch eine erste Temperiervorrichtung 140a, bspw. einen ersten resistiven Heizer 142a, der über einen ersten elektrischen Isolator 143a mit dem ersten Koppelelement 130a verbunden ist, auf eine erste Temperatur aufgeheizt wird. Ein zweites Wärmeleitrohr 120b überträgt eine zweite Wärmemenge zwischen einem zweiten Koppelelement 130b und der zweiten Elektrode 110b, wobei das zweite Koppelelement 130b durch eine zweite Temperiervorrichtung 140b, bspw. einen zweiten resistiven Heizer 142b, der über einen zweiten elektrischen Isolator 143b mit dem zweiten Koppelelement 130b verbunden ist, auf eine zweite Temperatur aufgeheizt wird. Damit können unterschiedliche oder gleiche erste oder zweite Temperaturen der Koppelelemente 130a und 130b und damit auch der Elektroden 110a und 110b eingestellt werden. Selbstverständlich können auch mehrere Wärmeleitrohre zur Übertragung der Wärme zwischen dem jeweiligen Koppelelement und der jeweiligen Elektrode eingesetzt werden, wobei die Anzahl der Wärmeleitrohre, ihre Ausgestaltung und/oder Anordnung gleich oder verschieden für die verschiedenen Systeme zur Temperierung einer Elektrode sein können.

Die Koppelelemente 130a und 130b sowie die Temperiervorrichtungen 140a und 140b sind beispielhaft außerhalb der Behandlungskammer 210 angeordnet, wie dies mit Bezug auf Fig. 6A erläutert wurde. Daher weist die Behandlungskammer 210 auch zwei Durchführungen 212a und 212b für die Wärmeleitrohre 120a bzw. 120b auf. Beispielhaft sind gleichartige Temperiervorrichtungen 140a und 140b dargestellt, jedoch können auch unterschiedliche Temperiervorrichtungen für jede der vorhandenen Elektroden oder eine gemeinsame Temperiervorrichtung für mehrere Elektroden eingesetzt werden.

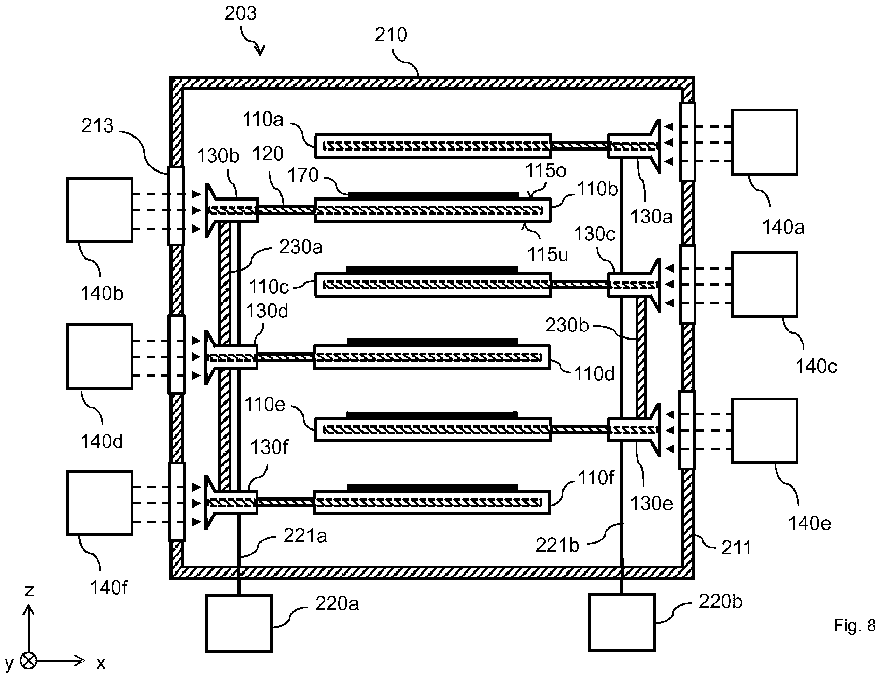

Figur 8 stellt schematisch ein viertes Beispiel 203 der erfindungsgemäßen Behandlungsanlage dar. Dabei ist in der Behandlungskammer 210 ein Elektrodenstapel bestehend aus mehreren übereinander angeordneten Elektroden 110a bis 110f angeordnet, wobei die Nutzflächen der jeweiligen Elektroden 110a bis 110f parallel zueinander in verschiedenen x-y-Ebenen, die entlang der z-Richtung angeordnet sind, verlaufen. Dabei weisen die äußeren Elektroden 110a und 110f des Elektrodenstapels jeweils nur eine Nutzfläche auf, die der benachbarten Elektrode, d.h. der Elektrode 110b bzw. der Elektrode 110e, zugewandt sind. Die inneren Elektroden 110b bis 110e weisen jeweils zwei sich gegenüberliegende Nutzflächen auf, welche jeweils einer Nutzfläche einer benachbarten Elektrode zugewandt sind. Beispielhaft ist für die Elektrode 110b eine obere Nutzfläche 115o und eine untere Nutzfläche 115u in Fig. 8 gekennzeichnet, wobei die obere Nutzfläche 115o der Nutzfläche der Elektrode 110a zugewandt ist, während die untere Nutzfläche 115u der oberen Nutzfläche der Elektrode 110c zugewandt ist. Selbstverständlich kann die Anzahl der Elektroden im Elektrodenstapel frei gewählt werden und ist nicht auf die dargestellte Anzahl von sechs Elektroden begrenzt. Beispielsweise sind Elektrodenstapel von 20, 50 oder sogar 100 übereinander angeordneten Elektroden bekannt, wobei auch mehrere Elektrodenstapel lateral nebeneinander angeordnet sein können.

Jede Elektrode 110a bis 110f wird über ein separates System zur Temperierung der jeweiligen Elektrode auf eine bestimmte Temperatur aufgeheizt oder abgekühlt. Dazu ist jede der Elektroden 110a bis 110f über mindestens ein Wärmeleitrohr 120, beispielhaft für die Elektrode 110b bezeichnet, mit einem Koppelelement 130a bis 130f verbunden. Im Beispiel 203 sind alle Koppelelemente 130a bis 130f innerhalb der Behandlungskammer 210 angeordnet und werden von als Infrarot-Strahler ausgebildeten Temperiervorrichtungen 140a bis 140f jeweils aufgeheizt. Dazu sind Strahlungsfenster 213 in jedem Strahlungsgang zwischen einer Temperiervorrichtung 140a bis 140f und dem dieser zugeordneten Koppelelement 130a bis 130f in der Wand 211 der Behandlungskammer 210 angeordnet, wie dies mit Bezug auf die Fig. 6B erläutert wurde. Prinzipiell können auch eine oder mehrere der Temperiervorrichtungen 140a bis 140f durch eine gemeinsame Temperiervorrichtung ersetzt werden, wenn gleiche Temperaturen an den jeweiligen zugeordneten Koppelelementen erreicht werden sollen.

Um eine Homogenisierung der Temperaturen über den Elektrodenstapel hinweg, also entlang der z-Richtung, zu erreichen, können darüber hinaus zusätzliche Wärmeleitrohre, die verschiedene Koppelelemente miteinander verbinden eingesetzt werden. Beispielhaft sind in Fig. 8 zwei zusätzliche Wärmeleitrohre 230a und 230b dargestellt. Dabei verbindet das Wärmeleitrohr 230a die Koppelelemente 130b, 130d und 130f miteinander, während das Wärmeleitrohr 230b die Koppelelemente 130c und 130e miteinander verbindet. Das Koppelelement 130a ist nicht durch das Wärmeleitrohr 230b mit anderen Koppelelementen verbunden, da bspw. die Elektrode 110a auf eine andere Temperatur als die Elektroden 110c und 110e temperiert werden soll. Selbstverständlich kann es aber auch bei einer entsprechend gewünschten Elektrodentemperatur über das Wärmeleitrohr 230b mit den Koppelelementen 130c und 130e verbunden sein. Die Nutzung von zwei verschiedenen zusätzlichen Wärmeleitrohren 230a und 230b ist durch die Potentialzuführung an die Elektroden über die jeweiligen Koppelelemente und Wärmeleitrohre und deren räumliche Anordnung begründet. Die Anordnung von zusätzlichen Wärmeleitrohren kann jedoch bei anderen Ausgestaltungen der Potentialzuführung und der Systeme zur Temperierung der Elektroden anders gestaltet werden.

Jeweils zwei benachbarte Elektroden bilden einen Plattenkondensator, wobei benachbarte Elektroden mit unterschiedlichen elektrischen Potentialen beaufschlagt werden können. Die Potentialbeaufschlagung erfolgt im Beispiel 203 durch eine elektrische Spannungszuführung an die Koppelelemente 130a bis 130f, wobei die Koppelelemente 130a bis 130f sowie die Wärmeleitrohre 120 elektrisch leitend ausgelegt sind. Beispielsweise werden die Elektroden 110b, 110d und 110f über die jeweiligen Koppelelemente 130b, 130d und 130f und die jeweiligen Wärmeleitrohre 120 von einer elektrischen Spannungsversorgung 220a über eine elektrische Zuleitung 221a mit einem ersten Potential beaufschlagt. Die Elektroden 110a, 110c und 110e werden über die jeweiligen Koppelelemente 130a, 130c und 130c und die jeweiligen Wärmeleitrohre 120 von einer elektrischen Spannungsversorgung 220b über eine elektrische Zuleitung 221b mit einem zweiten Potential beaufschlagt, wobei das zweite Potential verschieden von dem ersten Potential ist. Bei dieser alternierenden Potentialbeaufschlagung wird zwischen jeweils zwei benachbarten Elektroden ein elektrisches Feld gebildet, was bspw. zur Zündung eines Plasmas geeignet ist.

Um die Gefahr der Ausbildung parasitärer Plasmen zu verringern, sind die Koppelelemente 130a bis 130f von Elektroden, die mit einem verschiedenen Potential beaufschlagt werden, versetzt zueinander angeordnet. Im dargestellten Beispiel 203 sind alle gleichartig beaufschlagten Koppelelemente 130a, 130c und 130e auf der rechten Seite des Elektrodenstapels und alle gleichartig, jedoch mit einem anderen Potential beaufschlagten Koppelelemente 130b, 130d und 130f auf der linken Seite des Elektrodenstapels angeordnet. Das heißt, die Koppelelemente, die unterschiedlich beaufschlagten Elektroden zugeordnet sind, sind jeweils entlang der x-Richtung zueinander versetzt angeordnet. Dies ist insbesondere für Koppelelemente, die sich entlang der gesamten Ausdehnung der jeweiligen Elektrode in y-Richtung erstrecken, wie dies in den Figuren 5A und 5B dargestellt ist, vorteilhaft. Bei Koppelelementen, die sich nur über einen Teil der Ausdehnung der jeweiligen Elektrode in y-Richtung erstrecken, wie dies in Fig. 4 dargestellt ist, können die Koppelelemente aller Systeme zur Temperierung einer Elektrode auf einer Seite des Elektrodenstapels, d.h. auf einer Seite entlang der x-Richtung, angeordnet sein, wobei jedoch die Koppelelemente, die unterschiedlich beaufschlagten Elektroden zugeordnet sind, dann vorzugsweise entlang der y-Richtung versetzt angeordnet sind. Die Anordnung aller Koppelelemente auf einer Seite des Elektrodenstapels hat den Vorteil, dass alle Koppelelemente gegebenenfalls von einer Temperiervorrichtung erwärmt oder gekühlt werden können.

Ist ein zusätzliches Wärmeleitrohr vorhanden und elektrisch leitfähig ausgeführt, so können die damit verbundenen Koppelelemente und die dazugehörigen Elektroden auch über das zusätzliche Wärmeleitrohr mit einem Potential beaufschlagt werden.

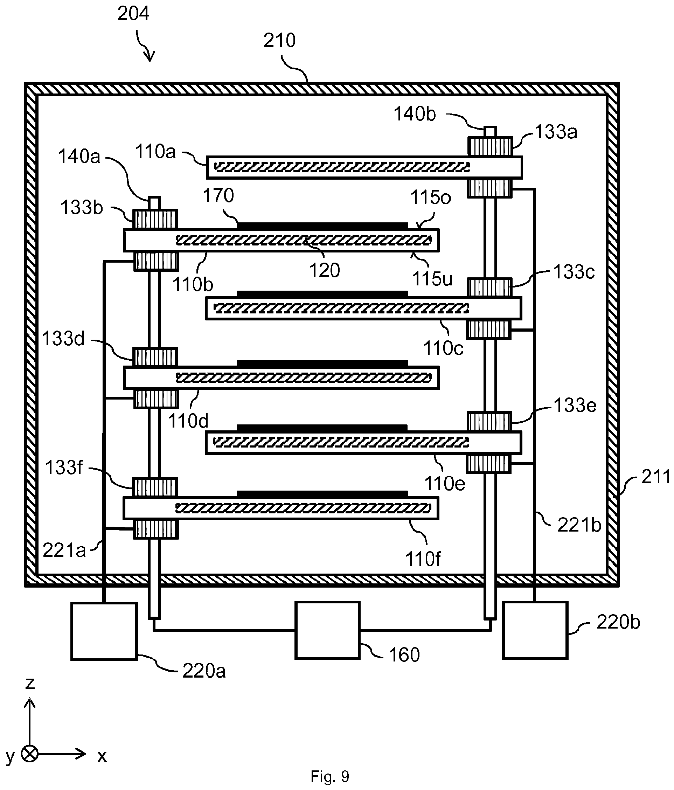

Figur 9 zeigt eine schematische Darstellung eines fünften Beispiels 204 der erfindungsgemäßen Behandlungsanlage, bei der - ähnlich wie im vierten Bespiel 203 aus Figur 8 - benachbarte Koppelelemente 133 in einem Stapel von übereinander angeordneten Elektroden 110 versetzt angeordnet sind und die Koppelelemente 133, die dasselbe elektrischen Potential aufweisen, über eine gemeinsame Temperiervorrichtung 140a bzw. 140b temperiert werden. Dabei kommt das mit Bezug auf die Figuren 3A bis 3C beschriebene System zur Temperierung der Elektroden zum Einsatz. Mit anderen Worten: Jede Elektrode 110a bis 110f weist in ihrem Inneren Wärmeleitrohre 120 auf, deren zweites Ende bis in einen Volumenbereich der jeweiligen Elektrode 110 reichen, von dem wenigstens eine der äußeren Oberflächen an das jeweilige Koppelelement 133a bis 133f angrenzt. Dabei sind die Koppelelemente 133 benachbarter Elektroden 110, die ein unterschiedliches elektrisches Potential aufweisen, auf entgegengesetzten Seiten der Elektroden 110 bezüglich der x-Richtung angeordnet. Das elektrische Potential wird den Elektroden 110a bis 110f über die Koppelelemente 133a bis 133f, die jeweils mit einer Spannungsversorgung 220a oder einer Spannungsversorgung 220b über elektrische Zuleitungen 221a bzw. 221b verbunden sind, zugeführt. Die Koppelelemente 133b, 133d und 133f, die auf einem ersten Potential liegen, sind über die erste Temperiervorrichtung 140a, die sich entlang der z-Richtung erstreckt, verbunden, wobei die erste Temperiervorrichtung 140a durch Öffnungen (Bohrungen) in den jeweiligen Koppelelementen 133b, 133d und 133f und in den jeweiligen Elektroden 110b, 110d und 110f geführt ist, und werden durch die erste Temperiervorrichtung 140a temperiert. In gleicher Weise werden die Koppelelemente 133a, 133c und 133e, die auf einem zweiten Potential liegen und durch die die zweite Temperiervorrichtung 140b verläuft, durch die zweite Temperiervorrichtung 140b temperiert. Die zweite Temperiervorrichtung 140b verläuft auch durch entsprechende Öffnungen in den Elektroden 110a, 110c und 110e. Die Koppelelemente 133 können sich jeweils bis nahe an die nächstliegenden Koppelelemente 133, die mit derselben Tempiervorrichtung 140a bzw. 140b verbunden sind, entlang der z-Richtung erstrecken, so dass fast die gesamte Temperiervorrichtung 140a bzw. 140b innerhalb der jeweiligen Koppelelemente 133 bzw. Elektroden 110 verläuft. Jedoch grenzen die Koppelelemente 133 vorzugsweise nicht direkt aneinander, um eine thermische Ausdehnung der Koppelelemente 133 bei erhöhten Temperaturen ausgleichen zu können. Alternativ können sich auch größere Bereiche der Temperiervorrichtungen 140a bzw. 140b außerhalb der Koppelelemente 133 und der Elektroden 110 befinden, wie dies in Fig. 9 angedeutet ist. In diesem Fall können vorzugsweise Infrarotstrahler, die nur in bestimmten Bereichen ihrer Ausdehnung eine große Wärmemenge abgeben, verwendet werden, wobei diese Bereiche dann von den Koppelelementen 133 und Elektroden 110 umgeben sind, während Bereiche des Infrarotstrahlers, welche nur wenig Infrarot-Strahlung erzeugen, außerhalb der Koppelelemente 133 und der Elektroden 110 angeordnet sind. Die Temperiervorrichtungen 140a und 140b sind durch die Wand 211 der Behandlungskammer 210 durchgeführt und außerhalb der Behandlungskammer 210 mit einer Steuereinheit 160 verbunden.

Dieses Ausführungsbeispiel hat die Vorteile eines sehr geringen Platzbedarfs innerhalb der Behandlungskammer 210, einer durch das Hüllrohr abgeschlossenen Luftatmosphäre für die Infrarot-Strahler, wie dies bereits mit Bezug auf die Figuren 3A bis 3C erläutert wurde, und von nur sehr wenigen notwendigen Vakuumdurchführungen durch die Wand 211 der Behandlungskammer 210.

Die Koppelelemente 133 können neben der Zuführung einer elektrischen Spannung auch zur Zuführung eines Prozessgases in Gasverteiler, die bspw. jeweils auf den unteren Nutzflächen 115u der Elektroden 110a bis 110e angeordnet sind, genutzt werden. Dies ist hier aus Gründen der Übersichtlichkeit nicht dargestellt.

Einige oder alle der genannten Möglichkeiten zur Ausgestaltung des erfindungsgemäßen Systems zur Temperierung einer Elektrode und der erfindungsgemäßen Behandlungsanlage können auch miteinander kombiniert werden, solange sie sich nicht gegenseitig ausschließen. Darüber hinaus können in verschiedenen Systemen zur Temperierung einer Elektrode unterschiedliche Temperiervorrichtungen und unterschiedliche Anzahlen, Ausgestaltungen und/oder Anordnungen von Wärmeleitrohren und Koppelelementen eingesetzt werden. Auch die Anzahl von Elektroden in einer Behandlungsanlage und die Anzahl, Ausgestaltung und/oder Anordnung der Koppelelemente und von zusätzlichen Wärmeleitrohren ist nicht auf die der dargestellten Beispiele begrenzt. Die angegebenen Werte für Abstände und Größen sind Richtwerte, die jedoch auch bei geeigneter Wahl der entsprechenden Komponenten über- oder unterschritten werden können.

### Bezugszeichen

- 100 - 105: System zur Temperierung einer Elektrode
- 110-114, 110a-110f: Elektrode
- 114o: Oberteil der Elektrode
- 114u: Unterteil der Elektrode
- 115: Nutzfläche der Elektrode
- 115o: Obere Nutzfläche der Elektrode
- 115u: Untere Nutzfläche der Elektrode
- 116: Seitenfläche der Elektrode
- 116u: Unterteil der Seitenfläche
- 117: Öffnung in Elektrode
- 118: Vertiefung für Substrathalter
- 120, 120a-120q, 1201, 1202: Wärmeleitrohr
- 121: Erstes Ende des Wärmeleitrohrs
- 122: Zweites Ende des Wärmeleitrohrs
- 130-134, 130a-130f: Koppelelement
- 132o, 134o: Oberteil des Koppelelements
- 132u, 134u: Unterteil des Koppelelements
- 135: Wärmeübertragungsfläche
- 135u: Unterteil der Wärmeübertragungsfläche
- 136: Geschwärzte Wärmeübertragungsfläche
- 137: Hochwärmeleitfähige Wärmeübertragungsfläche
- 140, 140a-140f: Temperiervorrichtung
- 141: Infrarot-Strahler
- 142: Resistiver Heizer
- 143: Elektrischer Isolator
- 144: Hüllrohr
- 145: Öffnung in Koppelelement
- 150: Temperaturmesseinheit
- 151: Pyrometer
- 152: Thermoelement
- 160: Steuereinheit
- 161: Steuerleitung
- 170: Substrat
- 180: Befestigungsloch
- 181: Befestigungsmittel
- 190: Halterungsöffnung

- 200 - 204: Behandlungsanlage
- 210: Behandlungskammer
- 211: Wand der Behandlungskammer
- 212: Durchführung für Wärmeleitrohr
- 213: Strahlungsfenster
- 220, 220a, 220b: Elektrische Spannungsversorgung
- 221, 221a, 221b: Elektrische Zuleitung
- 230a, 230b: Zusätzliches Wärmeleitrohr

- d₁: Abstand zwischen Elektrode und Koppelelement
- d₂: Abstand zwischen Koppelelement und Temperiervorrichtung

## Patentansprüche

1. System (100-105) zur Temperierung einer Elektrode (110-114; 110a-110f), aufweisend mindestens ein Wärmeleitrohr (120; 120a-120q; 1201, 1202), ein Koppelelement (130-134; 130a-130f) und eine Temperiervorrichtung (140; 140a-140f), wobei das Wärmeleitrohr (120; 120a-120q; 1201, 1202) zumindest teilweise und mit mindestens einem ersten Ende in der Elektrode (110-114; 110a-110f) anordenbar ist, das Koppelelement (130-134; 130a-130f) geeignet ist, ein zweites Ende des Wärmeleitrohrs (120; 120a-120q; 1201, 1202) aufzuheizen oder zu kühlen, und die Temperiervorrichtung (140; 140a-140f) geeignet ist, das Koppelelement (130-134; 130a-130f) aufzuheizen oder zu kühlen, wobei die Elektrode (110-114; 110a-110f) und die Temperiervorrichtung (140; 140a-140f) elektrisch voneinander getrennt sind.

2. System nach Anspruch 1, **dadurch gekennzeichnet, dass** das Koppelelement (130-134; 130a-130f) mindestens ein Teil einer Außenfläche der Elektrode (110-114; 110a-110f) ist, an den das zweite Ende des Wärmeleitrohrs (120; 120a-120q; 1201, 1202) angrenzt und der gegenüber anderen Bereichen der Elektrode (110-114; 110a-110f) einen erhöhten thermischen Absorptionsgrad aufweist.

3. System nach Anspruch 1, **dadurch gekennzeichnet, dass** das Koppelelement (130-134; 130a-130f) ein von der Elektrode (110-114; 110a-110f) getrennter Körper aus einem Material mit einer hohen Wärmeleitfähigkeit ist und in einem Bereich der Außenfläche der Elektrode (110-114; 110a-110f) anordenbar ist, der an einen Volumenbereich der Elektrode (110-114; 110a-110f) angrenzt, in dem mindestens das zweite Ende des Wärmeleitrohrs (120; 120a-120q; 1201, 1202) anordenbar ist.

4. System nach Anspruch 1, **dadurch gekennzeichnet, dass** das Koppelelement (130-134; 130a-130f) ein von der Elektrode (110-114; 110a-110f) getrennter Körper aus einem Material mit einer hohen Wärmeleitfähigkeit ist, in dem mindestens das zweite Ende des Wärmeleitrohrs (120; 120a-120q; 1201, 1202) angeordnet ist.

5. System nach Anspruch 3 oder 4, **dadurch gekennzeichnet, dass** das Koppelelement (130-134; 130a-130f) aus einem elektrisch leitenden Material besteht.

6. System nach Anspruch 3 oder 4, **dadurch gekennzeichnet, dass** das Koppelelement (130-134; 130a-130f) aus einem elektrisch isolierenden Material besteht.

7. System nach einem der Ansprüche 3 bis 6, **dadurch gekennzeichnet, dass** das Koppelelement (130-134; 130a-130f) eine Wärmeübertragungsfläche (135) aufweist, die einen gegenüber anderen Bereichen des Koppelelements (130-134; 130a-130f) erhöhten thermischen Absorptionsgrad oder eine erhöhte Wärmeleitfähigkeit aufweist.

8. System nach einem der vorhergehenden Ansprüche, **dadurch gekennzeichnet, dass** die Temperiervorrichtung (140; 140a-140f) ein Infrarot-Strahler (141), ein Induktor, ein resistiver Heizer (142) oder eine fluidbasierte Vorrichtung ist.

9. System nach einem der vorhergehenden Ansprüche, **dadurch gekennzeichnet, dass** das System weiterhin eine Temperaturmesseinheit (150) und eine Steuereinheit (160) enthält, wobei die Temperaturmesseinheit (150) geeignet ist, einen mit der Temperatur des Koppelelements (130-134; 130a-130f) verknüpften Parameter zu ermitteln, und die Steuereinheit (160) geeignet ist, die Temperiervorrichtung (140; 140a-140f) zu steuern.

10. Behandlungsanlage (200-204) mit einer Behandlungskammer (210) und mindestens einer Elektrode (110-114; 110a-110f) innerhalb der Behandlungskammer (210), **dadurch gekennzeichnet, dass** die Behandlungsanlage weiterhin mindestens ein System (100-105) zur Temperierung einer Elektrode nach einem der vorhergehenden Ansprüche aufweist.

11. Behandlungsanlage (200-204) nach Anspruch 10, **dadurch gekennzeichnet, dass** die Temperiervorrichtung (140; 140a-140f) mindestens eines ersten Systems (100-105) zur Temperierung einer Elektrode außerhalb der Behandlungskammer (210) angeordnet ist.

12. Behandlungsanlage (200-204) nach Anspruch 11, **dadurch gekennzeichnet, dass** das Koppelelement (130-134; 130a-130f) des ersten Systems (100-105) zur Temperierung einer Elektrode vollständig innerhalb der Behandlungskammer (210) angeordnet ist und die Temperiervorrichtung (140; 140a-140f) des ersten Systems (100-105) zur Temperierung einer Elektrode ein Infrarotstrahler (141) oder ein Induktor ist.

13. Behandlungsanlage (200-204) nach einem der Ansprüche 10 bis 12, **dadurch gekennzeichnet, dass** die Behandlungsanlage mehrere Elektroden (110-114; 110a-110f) und mehrere Systeme (100-105) zur Temperierung einer Elektrode aufweist, wobei die Koppelelemente (130-134; 130a-130f) von mindestens zwei Systemen (100-105) zur Temperierung einer Elektrode über mindestens ein zusätzliches Wärmeleitrohr (230a, 230b) miteinander verbunden sind.

14. Behandlungsanlage (200-204) nach einem der Ansprüche 10 bis 13, **dadurch gekennzeichnet, dass**
- die Behandlungsanlage mehrere Elektroden (110-114; 110a-110f) innerhalb der Behandlungskammer aufweist, deren Nutzflächen jeweils parallel zueinander und sich gegenüberliegend angeordnet sind und wobei benachbarte Elektroden (110-114; 110a-110f) so mit einer oder mehreren Spannungsversorgungen (220; 220a; 220b) verbunden sind, dass sie mit unterschiedlichen Elektrodenspannungen beaufschlagt werden können,
- die Systeme (100-105) zur Temperierung einer Elektrode jeweils Systeme nach Anspruch 3 oder 4 sind, bei dem das Koppelelement (130-134; 130a-130f) an mindestens einer seiner Außenflächen dasselbe Potential wie die zugeordnete Elektrode (110-114; 110a-110f) aufweist, und
- die Koppelelemente (130-134; 130a-130f) von Systemen zur Temperierung einer Elektrode (110-114; 110a-110f), welche benachbarten Elektroden (110-114; 110a-110f) zugeordnet sind, in mindestens einer Richtung senkrecht zum Abstand der benachbarten Elektroden (110-114; 110a-110f) versetzt zueinander angeordnet sind.

15. Behandlungsanlage (200-204) nach einem der Ansprüche 10 bis 14, **dadurch gekennzeichnet, dass** das Koppelelement (130-134; 130a-130f) mindestens eines Systems (100-105) zur Temperierung einer Elektrode mit einer Spannungsversorgung (220;220a;220b) verbunden ist und allein oder zusammen mit dem jeweiligen mindestens einen Wärmeleitrohr (120; 120a-120q; 1201, 1202) geeignet ist, die zugeordnete Elektrode (110-114; 110a-110f) mit einer Elektrodenspannung zu beaufschlagen.

## Claims

1. System (100-105) for temperature control of an electrode (110-114; 110a-110f), comprising at least one heat pipe (120; 120a-120q; 1201, 1202), a coupling element (130-134; 130a-130f) and a temperature control apparatus (140; 140a-140f), wherein the heat pipe (120; 120a-120q; 1201, 1202) is suited for being arranged in the electrode (110-114; 110a-110f) at least in part and with at least one first end, the coupling element (130-134; 130a-130f) is suitable for heating or cooling a second end of the heat pipe (120; 120a-120q; 1201, 1202), and the temperature control apparatus (140; 140a-140f) is suitable for heating or cooling the coupling element (130-134; 130a-130f), wherein the electrode (110-114; 110a-110f) and the temperature control apparatus (140; 140a-140f) are electrically separated from one another.

2. System according to claim 1, **characterised in that** the coupling element (130-134; 130a-130f) is at least a portion of an outer surface of the electrode (110-114; 110a-110f) which is adjoined by the second end of the heat pipe (120; 120a-120q; 1201, 1202) and which has an increased thermal absorption coefficient compared with other regions of the electrode (110-114; 110a-110f).

3. System according to claim 1, **characterised in that** the coupling element (130-134; 130a-130f) is a body that is separated from the electrode (110-114; 110a-110f) and consists of a material having a high level of thermal conductivity, and can be arranged in a region of the outer surface of the electrode (110-114; 110a-110f) that is adjacent to a volume region of the electrode (110-114; 110a-110f) in which at least the second end of the heat pipe (120; 120a-120q; 1201, 1202) is suited for being arranged.

4. System according to claim 1, **characterised in that** the coupling element (130-134; 130a-130f) is a body that is separated from the electrode (110-114; 110a-110f) and consists of a material having a high level of thermal conductivity, and in which at least the second end of the heat pipe (120; 120a-120q; 1201, 1202) is arranged.

5. System according to either claim 3 or claim 4, **characterised in that** the coupling element (130-134; 130a-130f) consists of an electrically conductive material.

6. System according to either claim 3 or claim 4, **characterised in that** the coupling element (130-134; 130a-130f) consists of an electrically insulating material.

7. System according to any of claims 3 to 6, **characterised in that** the coupling element (130-134; 130a-130f) comprises a heat transfer surface (135) that has an increased thermal absorption coefficient or an increased thermal conductivity compared with other regions of the coupling element (130-134; 130a-130f).

8. System according to any of the preceding claims, **characterised in that** the temperature control apparatus (140; 140a-140f) is an infrared radiator (141), an inductor, a resistive heater (142) or a fluid-based apparatus.

9. System according to any of the preceding claims, **characterised in that** the system furthermore contains a temperature measurement unit (150) and a control unit (160), the temperature measurement unit (150) being suitable for determining a parameter that is associated with the temperature of the coupling element (130-134; 130a-130f), and the control unit (160) being suitable for controlling the temperature control apparatus (140; 140a-140f).

10. Treatment facility (200-204) comprising a treatment chamber (210) and at least one electrode (110-114; 110a-110f) inside the treatment chamber (210), **characterised in that** the treatment facility furthermore comprises at least one system (100-105) according to any of the preceding claims for temperature control of an electrode.

11. Treatment facility (200-204) according to claim 10, **characterised in that** the temperature control apparatus (140; 140a-140f) of at least one first system (100-105) for temperature control of an electrode is arranged outside the treatment chamber (210).

12. Treatment facility (200-204) according to claim 11, **characterised in that** the coupling element (130-134; 130a-130f) of the first system (100-105) for temperature control of an electrode is arranged completely inside the treatment chamber (210), and the temperature control apparatus (140; 140a-140f) of the first system (100-105) for temperature control of an electrode is an infrared radiator (141) or an inductor.

13. Treatment facility (200-204) according to any of claims 10 to 12, **characterised in that** the treatment facility comprises a plurality of electrodes (110-114; 110a-110f) and a plurality of systems (100-105) for temperature control of an electrode, the coupling elements (130-134; 130a-130f) of at least two systems (100-105) for temperature control of an electrode being interconnected by means of at least one additional heat pipe (230a, 230b).

14. Treatment facility (200-204) according to any of claims 10 to 13, **characterised in that**
- the treatment facility comprises a plurality of electrodes (110-114; 110a-110f) inside the treatment chamber, the effective surfaces of which electrodes (110-114; 110a-110f) are in each case mutually parallel and mutually opposing, and adjacent electrodes (110-114; 110a-110f) being connected to one or more voltage supplies (220; 220a; 220b), such that different electrode voltages can be applied to said electrodes (110-114; 110a-110f),
- the systems (100-105) for temperature control of an electrode are each systems according to either claim 3 or claim 4 in which the coupling element (130-134; 130a-130f) has the same potential, at at least one of the outer surfaces thereof, as the associated electrode (110-114; 110a-110f), and
- the coupling elements (130-134; 130a-130f) of systems for temperature control of an electrode (110-114; 110a-110f), which coupling elements (130-134; 130a-130f) are associated with neighbouring electrodes (110-114; 110a-110f), are arranged so as to be mutually offset at least in a direction perpendicular to the spacing of the neighbouring electrodes (110-114; 110a-110f).

15. Treatment facility (200-204) according to any of claims 10 to 14, **characterised in that** the coupling element (130-134; 130a-130f) of at least one system (100-105) for temperature control of an electrode is connected to a voltage supply (220; 220a; 220b) and is suitable, alone or together with the relevant at least one heat pipe (120; 120a-120q; 1201, 1202), for applying an electrode voltage to the associated electrode (110-114; 110a-110f).

## Revendications

1. Système (100-105) de régulation de température d'une électrode (110-114 ; 110a-110f), présentant au moins un tube thermoconducteur (120 ; 120a-120q ; 1201, 1202), un élément de couplage (130-134 ; 130a-130f) et un dispositif de régulation de température (140 ; 140a-140f), le tube thermoconducteur (120 ; 120a-120q ; 1201, 1202) étant agençable au moins partiellement et avec au moins une première extrémité dans l'électrode (110-114 ; 110a-110f), l'élément de couplage (130-134 ; 130a-130f) étant conçu pour chauffer ou pour refroidir une seconde extrémité du tube thermoconducteur (120 ; 120a-120q ; 1201, 1202) et le dispositif de régulation de température (140 ; 140a-140f) étant conçu pour chauffer ou pour refroidir l'élément de couplage (130-134 ; 130a-130f), l'électrode (110-114 ; 110a-110f) et le dispositif de régulation de température (140 ; 140a-140f) étant isolés électriquement l'un de l'autre.

2. Système selon la revendication 1, **caractérisé en ce que** l'élément de couplage (130-134 ; 130a-130f) constitue au moins une partie d'une surface externe de l'électrode (110-114 ; 110a-110f), à laquelle la seconde extrémité du tube thermoconducteur (120 ; 120a-120q ; 1201, 1202) est adjacente, et laquelle présente un degré d'absorption thermique accru par rapport à d'autres zones de l'électrode (110-114 ; 110a-110f).

3. Système selon la revendication 1, **caractérisé en ce que** l'élément de couplage (130-134 ; 130a-130f) est un corps isolé de l'électrode (110-114 ; 110a-110f) en un matériau comportant une conductivité thermique élevée et peut être agencé dans une zone de la surface externe de l'électrode (110-114 ; 110a-110f) qui est adjacente à une zone de volume de l'électrode (110-114 ; 110a-110f) dans laquelle au moins la seconde extrémité du tube thermoconducteur (120 ; 120a-120q ; 1201, 1202) peut être agencée.

4. Système selon la revendication 1, **caractérisé en ce que** l'élément de couplage (130-134 ; 130a-130f) est un corps isolé de l'électrode (110-114 ; 110a-110f) en un matériau comportant une conductivité thermique élevée, dans lequel au moins la seconde extrémité du tube thermoconducteur (120 ; 120a-120q ; 1201, 1202) est agencée.

5. Système selon la revendication 3 ou 4, **caractérisé en ce que** l'élément de couplage (130-134 ; 130a-130f) est constitué d'un matériau électriquement conducteur.

6. Système selon la revendication 3 ou 4, **caractérisé en ce que** l'élément de couplage (130-134 ; 130a-130f) est constitué d'un matériau électriquement isolant.

7. Système selon l'une des revendications 3 à 6, **caractérisé en ce que** l'élément de couplage (130-134 ; 130a-130f) présente une surface de transfert de chaleur (135) qui présente un degré d'absorption thermique accru ou une conductivité thermique accrue par rapport à d'autres zones de l'élément de couplage (130-134 ; 130a-130f).

8. Système selon l'une des revendications précédentes, **caractérisé en ce que** le dispositif de régulation de température (140 ; 140a-140f) est un émetteur infrarouge (141), un inducteur, un appareil de chauffage résistif (142) ou un dispositif à base de fluide.

9. Système selon l'une des revendications précédentes, **caractérisé en ce que** le système contient en outre une unité de mesure de température (150) et une unité de commande (160), dans lequel l'unité de mesure de température (150) est conçue pour déterminer un paramètre associé à la température de l'élément de couplage (130-134 ; 130a-130f) et l'unité de commande (160) est conçue pour commander le dispositif de régulation de température (140 ; 140a-140f).

10. Installation de traitement (200-204) comportant une chambre de traitement (210) et au moins une électrode (110-114 ; 110a-110f) à l'intérieur de la chambre de traitement (210), **caractérisée en ce que** l'installation de traitement présente en outre au moins un système (100-105) pour la régulation de température d'une électrode selon l'une des revendications précédentes.

11. Installation de traitement (200-204) selon la revendication 10, **caractérisée en ce que** le dispositif de régulation de température (140 ; 140a-140f) d'au moins un premier système (100-105) pour la régulation de température d'une électrode est agencé à l'extérieur de la chambre de traitement (210).

12. Installation de traitement (200-204) selon la revendication 11, **caractérisée en ce que** l'élément de couplage (130-134 ; 130a-130f) du premier système (100-105) pour la régulation de température d'une électrode est agencé entièrement à l'intérieur de la chambre de traitement (210) et le dispositif de régulation de température (140 ; 140a-140f) du premier système (100-105) pour la régulation de température d'une électrode est un émetteur infrarouge (141) ou un inducteur.

13. Installation de traitement (200-204) selon l'une des revendications 10 à 12, **caractérisée en ce que** l'installation de traitement présente plusieurs électrodes (110-114 ; 110a-110f) et plusieurs systèmes (100-105) pour la régulation de température d'une électrode, les éléments de couplage (130-134 ; 130a-130f) d'au moins deux systèmes (100-105) pour la régulation de température d'une électrode étant reliés l'un à l'autre par l'intermédiaire d'au moins un tube thermoconducteur (230a, 230b) supplémentaire.

14. Installation de traitement (200-204) selon l'une des revendications 10 à 13, **caractérisée en ce que**
- l'installation de traitement présente plusieurs électrodes (110-114 ; 110a-110f) à l'intérieur de la chambre de traitement, dont les surfaces utiles sont respectivement parallèles les unes aux autres et sont agencées en regard les unes des autres, et des électrodes (110-114 ; 110a-110f) voisines étant reliées à une ou plusieurs alimentations en tension (220 ; 220a ; 220b) de manière à pouvoir être sollicitées par des tensions d'électrode différentes,
- les systèmes (100-105) pour la régulation de température d'une électrode sont respectivement des systèmes selon la revendication 3 ou 4, dans lesquels l'élément de couplage (130-134 ; 130a-130f) présente sur au moins l'une de ses surfaces externes le même potentiel que l'électrode (110-114 ; 110a-110f) associée, et
- les éléments de couplage (130-134 ; 130a-130f) de systèmes pour la régulation de température d'une électrode (110-114 ; 110a-110f) qui sont associés à des électrodes (110-114 ; 110a- 110f) voisines sont agencés de manière décalée les uns par rapport aux autres dans au moins une direction perpendiculairement à l'espacement des électrodes (110-114 ; 110a-110f) voisines.

15. Installation de traitement (200-204) selon l'une des revendications 10 à 14, **caractérisée en ce que** l'élément de couplage (130-134 ; 130a-130f) d'au moins un système (100-105) pour la régulation de température d'une électrode est relié à une alimentation en tension (220 ; 220a ; 220b) et est conçu, seul ou conjointement avec l'au moins un tube thermoconducteur (120 ; 120a-120q ; 1201, 1202) respectif, pour solliciter l'électrode (110-114 ; 110a-110f) associée avec une tension d'électrode.
